(19) Europäisches Patentamt
European Patent Office
Office européen des brevets

(11) EP 3 858 932 A1

(12) **EUROPEAN PATENT APPLICATION**
published in accordance with Art. 153(4) EPC

(43) Date of publication:
**04.08.2021 Bulletin 2021/31**

(21) Application number: **19867143.0**

(22) Date of filing: **25.09.2019**

(51) Int Cl.:
***C09J 7/38*** *(2018.01)* ***C09J 5/00*** *(2006.01)*
***C09J 11/06*** *(2006.01)* ***C09J 201/00*** *(2006.01)*
***H01L 21/304*** *(2006.01)*

(86) International application number:
**PCT/JP2019/037719**

(87) International publication number:
**WO 2020/067221 (02.04.2020 Gazette 2020/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **28.09.2018 JP 2018184565**

(71) Applicant: **NITTO DENKO CORPORATION**
**Ibaraki-shi**
**Osaka 567-8680 (JP)**

(72) Inventors:
- **AWANE, Ryo**
**Ibaraki-shi, Osaka 567-8680 (JP)**
- **HIRAO, Akira**
**Ibaraki-shi, Osaka 567-8680 (JP)**
- **AKAMATSU, Kaori**
**Ibaraki-shi, Osaka 567-8680 (JP)**
- **MIZOBATA, Kaori**
**Ibaraki-shi, Osaka 567-8680 (JP)**

(74) Representative: **Gill Jennings & Every LLP**
**The Broadgate Tower**
**20 Primrose Street**
**London EC2A 2ES (GB)**

(54) **ADHEREND SEPARATION METHOD AND JOINING METHOD**

(57) The present invention relates to a separation method for an adherend including: a first voltage application step of applying a voltage to an electrolyte-containing adhesive layer to change an adhesive force so as to generate a potential difference in a thickness direction of the electrolyte-containing adhesive layer in a state where the electrolyte-containing adhesive layer in an adhesive sheet containing at least the electrolyte-containing adhesive layer is allowed to bond to an adherend; a bonding maintenance step of recovering the adhesive force by allowing a predetermined time to elapse in the state where the electrolyte-containing adhesive layer is allowed to bond to the adherend, after the first voltage application step; a second voltage application step of applying a voltage to the electrolyte-containing adhesive layer to change the adhesive force so as to generate a potential difference in the thickness direction of the electrolyte-containing adhesive layer in the state where the electrolyte-containing adhesive layer is allowed to bond to the adherend, after the bonding maintenance step; and a separation step of separating the electrolyte-containing adhesive layer and the adherend.

**FIG. 1**

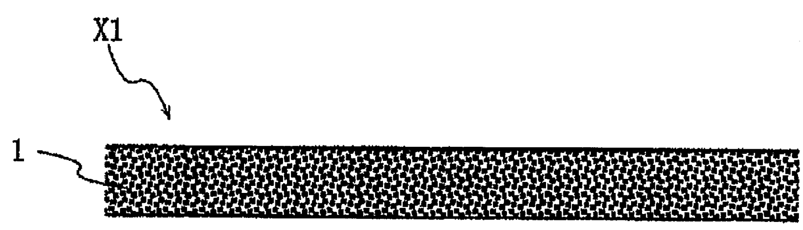




Printed by Jouve, 75001 PARIS (FR)

## Description

TECHNICAL FIELD

The present invention relates to a separation method and a bonding method for an adherend.

BACKGROUND ART

In a process for producing an electronic component and the like, demand in regard to rework for improving yield and in regard to recycle of disassembling and recovering components after use has been increased. To meet the demand, a double-sided adhesive sheet having certain adhesive force and also having certain debondability is sometimes utilized in allowing members to adhere to each other in the process of producing an electronic component and the like.

As the double-sided adhesive sheet for realizing the above-described adhesive force and debondability, adhesive sheets (electrically debondable adhesive sheets) that uses an ionic liquid containing a cation and an anion in a component constituting an adhesive composition and that can be debonded by applying a voltage to an adhesive layer are known (Patent Literatures 1 to 3).

In the electrically debondable adhesive sheets of Patent Literatures 1 to 3, it is considered that when a voltage is applied, the cation of the ionic liquid moves and reduction occurs in a cathode side, the anion of the ionic liquid moves and oxidation occurs in an anode side, adhesive force at an adhesive interface is weakened, and as a result, the adhesive sheet is easy to be debonded.

CITATION LIST

PATENT LITERATURE

Patent Literature 1: JP 2010-037354 A
Patent Literature 2: Japanese Patent No. 6097112
Patent Literature 3: Japanese Patent No. 4139851

SUMMARY OF INVENTION

TECHNICAL PROBLEM

The electrically debondable adhesive sheet can firmly adhere to the members when no voltage is applied and can be debonded with small force when a voltage is applied. However, in the cases where a voltage is applied by mistake, where debonding is no longer necessary after voltage application, where only a part of the adhesive sheet is to be debonded, or the like, it is preferable that the members can be allowed to firmly bond to each other by the recovery of the adhesive force in a predetermined time after a voltage has been applied, and the debonding can be performed with a small force when the voltage is applied again. For work safety, there is a need for a separation method for an adherend in which the adherend can be separated even after the voltage application is stopped, the members can be allowed to firmly bond to each other by the recovery of the adhesive force after a predetermined time, and the adherend can be easily separated by applying a voltage again.

The present invention has been made in view of the above, and an object of the present invention is to provide a separation method for an adherend which allows members to firmly bond to each other by the recovery of an adhesive force when a predetermined time elapses after a voltage has been applied and allows an adherend to be easily separated by applying a voltage again. Another object of the present invention is to provide a bonding method in which members can be allowed to firmly bond to each other by the recovery of the adhesive force when a predetermined time elapses after a voltage has been applied.

SOLUTION TO PROBLEM

As a result of diligent studies to solve the above problems, the present inventors have found that the use of an adhesive sheet containing at least an electrolyte-containing adhesive layer allows members to firmly bond to each other by the recovery of the adhesive force when a predetermined time elapses after a voltage has been applied, and the adherend can be easily separated by applying a voltage again. The present invention has been completed based on these findings.

That is, the above object of the present invention is achieved by the following means.

[1] A separation method for an adherend, comprising:

a first voltage application step of applying a voltage to an electrolyte-containing adhesive layer to change an adhesive force so as to generate a potential difference in a thickness direction of the electrolyte-containing adhesive layer in a state where the electrolyte-containing adhesive layer in an adhesive sheet containing at least the electrolyte-containing adhesive layer is allowed to bond to an adherend;
a bonding maintenance step of recovering the adhesive force by allowing a predetermined time to elapse in the state where the electrolyte-containing adhesive layer is allowed to bond to the adherend, after the first voltage application step;
a second voltage application step of applying a voltage to the electrolyte-containing adhesive layer to change the adhesive force so as to generate a potential difference in the thickness direction of the electrolyte-containing adhesive layer in the state where the electrolyte-containing adhesive layer is allowed to bond to the adherend, after the bonding maintenance step; and
a separation step of separating the electrolyte-containing adhesive layer and the adherend.

[2] The separation method for an adherend according to [1], wherein the second voltage application step and the separation step are performed at the same time.
[3] The separation method for an adherend according to [1], wherein the separation step is performed after the second voltage application step.
[4] The separation method for an adherend according to any one of [1] to [3], wherein in the bonding maintenance step, a recovery rate of the adhesive force of the electrolyte-containing adhesive layer is 30% or less 30 seconds after applying the voltage is stopped.
[5] The separation method for an adherend according to any one of [1] to [4], wherein both of the voltage applied in the first voltage application step and the voltage applied in the second voltage application step are 20 V or less.
[6] The separation method for an adherend according to any one of [1] to [5], wherein
one surface of the electrolyte-containing adhesive layer is allowed to bond to a first conductive adherend, and the other surface of the electrolyte-containing adhesive layer is allowed to bond to a second conductive adherend, and in the first voltage application step and the second voltage application step, the voltage is applied to the electrolyte-containing adhesive layer via the first conductive adherend and the second conductive adherend.
[7] The separation method for an adherend according to any one of [1] to [5], wherein
the adhesive sheet has a laminate structure including the electrolyte-containing adhesive layer, a first adhesive layer, and a conductive layer located between the electrolyte-containing adhesive layer and the first adhesive layer and bonding to the electrolyte-containing adhesive layer,
the electrolyte-containing adhesive layer is allowed to bond to a conductive adherend, and the first adhesive layer is allowed to bond to another adherend, and
in the first voltage application step and the second voltage application step, the voltage is applied to the electrolyte-containing adhesive layer via the conductive layer and the conductive adherend.
[8] The separation method for an adherend according to any one of [1] to [5], wherein
the adhesive sheet has a laminate structure including a first adhesive layer, the electrolyte-containing adhesive layer, a second adhesive layer, a first conductive layer located between the first adhesive layer and the electrolyte-containing adhesive layer and bonding to the electrolyte-containing adhesive layer, and a second conductive layer located between the second adhesive layer and the electrolyte-containing adhesive layer and bonding to the electrolyte-containing adhesive layer,
the first adhesive layer is allowed to bond to a first adherend, and the second adhesive layer is allowed to bond to a second adherend,
in the first voltage application step and the second voltage application step, the voltage is applied to the electrolyte-containing adhesive layer via the first conductive layer and the second conductive layer.
[9] The separation method for an adherend according to any one of [1] to [8], wherein the electrolyte-containing adhesive layer has a thickness of 1 μm or more and 1,000 μm or less.
[10] The separation method for an adherend according to any one of [1] to [9], wherein in the first voltage application step and the second voltage application step, an application time of the voltage is 60 seconds or shorter.
[11] The separation method for an adherend according to any one of [1] to [10], wherein the electrolyte is an ionic liquid.
[12] The separation method for an adherend according to any one of [1] to [11], wherein the electrolyte-containing adhesive layer has a water content of 0.4% or more after being stored in an environment of 23°C × 50% for 3 days.
[13] The separation method for an adherend according to [11], wherein a cation of the ionic liquid is at least one cation selected from the group consisting of an imidazolium-based cation, a pyridinium-based cation, a pyrrolidinium-based cation, and an ammonium-based cation.

[14] The separation method for an adherend according to [13], wherein a molecular weight of the cation of the ionic liquid is 300 or less.

[15] The separation method for an adherend according to any one of [11] to [14], wherein a polymer is contained in an adhesive composition for forming the electrolyte-containing adhesive layer, and the content of the electrolyte is 0.5 parts by mass or more and 30 parts by mass or less, per 100 parts by mass of the polymer.

[16] A bonding method comprising:

a first voltage application step of applying a voltage to an electrolyte-containing adhesive layer to change an adhesive force so as to generate a potential difference in a thickness direction of the electrolyte-containing adhesive layer in a state where the electrolyte-containing adhesive layer in an adhesive sheet containing at least the electrolyte-containing adhesive layer is allowed to bond to an adherend; and

a bonding maintenance step of recovering the adhesive force by allowing a predetermined time to elapse in the state where the electrolyte-containing adhesive layer is allowed to bond to the adherend, after the first voltage application step.

## ADVANTAGEOUS EFFECTS OF INVENTION

The separation method for an adherend according to the present invention allows members to firmly bond to each other by the recovery of the adhesive force when a predetermined time elapses after a voltage has been applied, and can easily separate the adherend by applying the voltage again. In addition, the bonding method for an adherend according to the present invention can firmly allow members to bond to each other by recovering the adhesive force when a predetermined time elapses after a voltage has been applied.

## BRIEF DESCRIPTION OF DRAWINGS

FIG. 1 is a sectional view illustrating an example of an adhesive sheet for use in a separation method and a bonding method for an adherend according to the present invention.

FIG. 2 is a sectional view illustrating an example of a laminate structure of the adhesive sheet for use in the separation method and the bonding method for an adherend according to the present invention.

FIG. 3 is a sectional view illustrating an example of the laminate structure of the adhesive sheet for use in the separation method and the bonding method for an adherend according to the present invention.

FIG. 4 is a sectional view illustrating another example of the laminate structure of the adhesive sheet for use in the separation method and the bonding method for an adherend according to the present invention.

FIG. 5 is a sectional view illustrating yet another example of the laminate structure of the adhesive sheet for use in the separation method and the bonding method for an adherend according to the present invention.

FIG. 6 is a sectional view illustrating still another example of the laminate structure of the adhesive sheet for use in the separation method and the bonding method for an adherend according to the present invention.

FIG. 7 is a sectional view illustrating an overview of a method of a 180° peeling test in Examples.

## DESCRIPTION OF EMBODIMENTS

Hereinafter, the embodiments for performing the present invention are described in detail. The present invention is not limited to the embodiment to be described below.

A bonding method for an adherend according to an embodiment of the present invention includes:

a first voltage application step of applying a voltage to an electrolyte-containing adhesive layer to change an adhesive force so as to generate a potential difference in a thickness direction of the electrolyte-containing adhesive layer in a state where the electrolyte-containing adhesive layer in an adhesive sheet containing at least the electrolyte-containing adhesive layer is allowed to bond to an adherend; and

a bonding maintenance step of recovering the adhesive force by allowing a predetermined time to elapse in the state where the electrolyte-containing adhesive layer is allowed to bond to the adherend, after the first voltage application step.

The bonding method for an adherend according to the embodiment of the present invention includes the first voltage application step and the bonding maintenance step, and may further include an optional step in addition to the

above steps, and each of the steps may be included any number of times. The following configurations can be exemplified.
first voltage application step/bonding maintenance step
first voltage application step/first voltage application step/bonding maintenance step
first voltage application step/separation step/bonding step/bonding maintenance step

A separation method for an adherend according to an embodiment of the present invention includes:

a first voltage application step of applying a voltage to an electrolyte-containing adhesive layer to change an adhesive force so as to generate a potential difference in a thickness direction of the electrolyte-containing adhesive layer in a state where the electrolyte-containing adhesive layer in an adhesive sheet containing at least the electrolyte-containing adhesive layer is allowed to bond to an adherend;
a bonding maintenance step of recovering the adhesive force by allowing a predetermined time to elapse in the state where the electrolyte-containing adhesive layer is allowed to bond to the adherend, after the first voltage application step;
a second voltage application step of applying a voltage to the electrolyte-containing adhesive layer to change the adhesive force so as to generate a potential difference in the thickness direction of the electrolyte-containing adhesive layer in the state where the electrolyte-containing adhesive layer is allowed to bond to the adherend, after the bonding maintenance step; and
a separation step of separating the electrolyte-containing adhesive layer and the adherend.

The separation method for an adherend according to the embodiment of the present invention includes the first voltage application step, the bonding maintenance step, the second voltage application step, and the separation step, and may further include an optional step in addition to the above steps, and each of the steps may be included any number of times. The following configurations can be exemplified.
first voltage application step/first voltage application step/bonding maintenance step/second voltage application step/separation step
first voltage application step/bonding maintenance step/second voltage application step/separation step/bonding step/bonding maintenance step
first voltage application step/separation step/bonding step/bonding maintenance step/second voltage application step/separation step

In the present invention, the term "bonding (bonding method)" means allowing an adherend to bond to an electrolyte-containing adhesive layer of an adhesive sheet (hereinafter, may be referred to as "electrolyte-containing adhesive layer"), and the term "separation (separation method)" means separating the adherend from the electrolyte-containing adhesive layer of the adhesive sheet. In the present invention, "bonding" and "separation" are not limited to being performed once, and may be repeated as many times as necessary. In the present invention, one in which the adhesive sheet and at least one adherend are allowed to bond to each other via the electrolyte-containing adhesive layer of the adhesive sheet is referred to as an "adhesive sheet adhered body".

In the embodiment of the present invention, the adhesive sheet may include at least one electrolyte-containing adhesive layer as an adhesive layer, and may further include other adhesive layers (hereinafter, may be referred to as a "first adhesive layer" and a "second adhesive layer"). The first adhesive layer and the second adhesive layer may be an electrolyte-containing adhesive layer or an adhesive layer free of an electrolyte (hereinafter, may be referred to as an "electrolyte-free adhesive layer"). In the embodiment of the present invention, the adhesive sheet may be a double-sided adhesive sheet having adhesive surfaces on both sides, or may be a single-sided adhesive sheet having an adhesive surface on only one side. The adhesive sheet may include an electrolyte-free adhesive layer, a substrate, a conductive layer, a conduction substrate, or the like, in addition to the electrolyte-containing adhesive layer. In the embodiment of the present invention, the adherend in the adhesive sheet adhered body may be a conductive adherend that conducts electricity or a non-conductive adherend that does not conduct electricity. Details of the adhesive sheet and the adhesive sheet adhered body will be described later.

The first voltage application step is a step of applying a voltage to an electrolyte-containing adhesive layer to change an adhesive force so as to generate a potential difference in a thickness direction of the electrolyte-containing adhesive layer in a state where the electrolyte-containing adhesive layer in an adhesive sheet containing at least the electrolyte-containing adhesive layer is allowed to bond to an adherend.

The second voltage application step is a step of applying a voltage to the adhesive layer to change the adhesive force so as to generate a potential difference in the thickness direction of the electrolyte-containing adhesive layer in the state where the electrolyte-containing adhesive layer is allowed to bond to the adherend, after bonding maintenance step.

In the embodiment of the present invention, one surface of the electrolyte-containing adhesive layer is allowed to bond to a first conductive adherend, and the other surface of the electrolyte-containing adhesive layer is allowed to bond to a second conductive adherend, and in the first voltage application step and the second voltage application step,

the voltage can be applied to the electrolyte-containing adhesive layer via the first conductive adherend and the second conductive adherend. The first conductive adherend and the second conductive adherend may be the same as or different from each other, and are conductive adherends to be described later.

In the separation method according to the present embodiment, for example, a current is carried to the first conductive adherend and the second conductive adherend, a voltage is applied via the first conductive adherend and the second conductive adherend to generate a potential difference in the thickness direction of the electrolyte-containing adhesive layer, and thus at least one of the first conductive adherend and the second conductive adherend can be separated from the electrolyte-containing adhesive layer.

In addition, examples of the bonding method according to the present embodiment include a method of allowing the above electrolyte-containing adhesive layer to bond to the first conductive adherend and/or a method of allowing the electrolyte-containing adhesive layer to bond to the second adherend. The first conductive adherend and the second conductive adherend separated by the above separation method can be allowed to bond by the above bonding method and then separated again by the above separation method. The above separation method and bonding method are preferably used when bonding and separating two conductive adherends.

In the present embodiment, as described above, the voltage is applied so as to generate a potential difference in the thickness direction of the electrolyte-containing adhesive layer of the adhesive sheet. The adhesive force of the electrolyte-containing adhesive layer can be changed by applying a voltage, and the adhesive force of the electrolyte-containing adhesive layer is preferably decreased by applying a voltage. Due to the voltage application, the orientation of the electrolyte in the electrolyte-containing adhesive layer changes and the electrolyte substance moves in the thickness direction of the electrolyte-containing adhesive layer, and the surface composition of the electrolyte-containing adhesive layer changes. Accordingly, electrical debondability of decreasing the adhesive force to the adherend is obtained.

Thus, the voltage application in a longer time equates to the lower adhesive force of the electrolyte-containing adhesive layer and the higher electrical debondability of the electrolyte-containing adhesive layer as a tendency. Thus, the bonded adherend is separated from the electrolyte-containing adhesive layer. In the present invention, the adherend can be easily separated by applying a low voltage, and the bonding or separating work can be performed even with a simple device such as a device using a dry battery, so that the workability is good.

In the embodiment of the present invention, the voltage to be applied to the electrolyte-containing adhesive layer is preferably 1 V or more, more preferably 3 V or more, and still more preferably 6 V or more. In addition, the voltage to be applied to the electrolyte-containing adhesive layer is preferably 100 V or less, more preferably 50 V or less, still more preferably 30 V or less, even more preferably 20 V or less, and particularly preferably 15 V or less.

The voltage application time is preferably 60 seconds or shorter, more preferably 40 seconds or shorter, still more preferably 20 seconds or shorter, and particularly preferably 10 seconds or shorter. In such a case, the workability is excellent. A shorter application time is preferred, but the application time is typically 1 second or longer.

The bonding maintenance step is a step of recovering the adhesive force by allowing a predetermined time to elapse in the state where the electrolyte-containing adhesive layer is allowed to bond to the adherend, after the first voltage application step.

In the embodiment of the present invention, when a certain period of time (for example, 30 minutes) elapses after the voltage application is stopped, the surface composition of the electrolyte-containing adhesive layer returns to the original state. Thus, the adhesive force can be recovered by allowing a predetermined time to elapse and the bonding can be maintained.

In order to recover the adhesive force, a predetermined time may be allowed to elapse in the state where the electrolyte-containing adhesive layer is allowed to bond to the adherend after the first voltage application step, preferably 30 minutes or longer, and more preferably 60 minutes or longer. As the adhesive force recovers after a predetermined time elapses, the adherend can be allowed to bond without pressing and attaching the adhesive sheet again, which has advantages such as improvement in process efficiency.

The adhesive force (initial adhesive force) of the electrolyte-containing adhesive layer when no voltage is applied (normally) is not limited, but the adhesive force in a 180° peeling test at 23°C (tensile rate: 300 mm/min) is preferably 0.1 or more and 40 or less. The upper limit of the adhesive force is more preferably 20, still more preferably 10, and particularly preferably 5. The lower limit of the adhesive force is more preferably 0.3, still more preferably 0.5, and particularly preferably 0.8. When the adhesive force is less than 0.1, the adhesive force may not be sufficient and the adhesive sheet may be debonded, and when the adhesive force is more than 40, the adhesive sheet may not be debonded even when a voltage is applied. The unit of the adhesive force is N/20 mm. The initial adhesive force is an adhesive force when an adhesive sheet is attached to an adherend (SUS304), pressed by reciprocating a 2 kg roller once, left for 30 minutes, and then peeled at 180° with a peeling tester.

The change in the adhesive force of the electrolyte-containing adhesive layer according to the present embodiment is preferably a decrease in the adhesive force. A rate of decrease in adhesive force (simply expressed as "adhesive force during voltage application" in the following equation (A)) determined according to the following equation (A) based on the adhesive force measured under the above conditions and the initial adhesive force is preferably 60% or more,

more preferably 70% or more, and still more preferably 80% or more.

$$\text{Rate of decrease in adhesive force (\%)} = \{1 - (\text{adhesive force during voltage application / initial adhesive force})\} \times 100 \qquad (C)$$

The adhesive force (debonding force) of the electrolyte-containing adhesive layer after the voltage application (10 seconds after the voltage is stopped) is not limited, but is preferably 1.0 or less, more preferably 0.5 or less, still more preferably 0.3 or less, and particularly preferably 0.1 or less, as the adhesive force in the 180° peeling test (tensile rate: 300 mm/min). When the adhesive force is more than 1.0, the adhesive sheet may not be debonded from the adherend. The unit of the adhesive force is N/20 mm. The above adhesive force is an adhesive force when an adhesive sheet is attached to an adherend (SUS304), pressed by reciprocating a 2 kg roller once, left for 30 minutes, applied with a voltage of 10 V for 10 seconds, and then peeled at 180° with a peeling tester after 10 seconds after the voltage is stopped.

The adhesive force recovery rate of the electrolyte-containing adhesive layer after the voltage application [(adhesive force of adhesive sheet after voltage application (30 seconds after voltage application) / initial adhesive force) × 100] is not limited, but is preferably 30% or less, more preferably 20% or less, still more preferably 10% or less, and particularly preferably 6% or less. The above adhesive force recovery rate is an adhesive force recovery rate 30 seconds after the voltage application is stopped. When the adhesive force recovery rate is more than 30%, the adhesive force is recovered within a short period of time (for example, 3 seconds) after the voltage application is stopped even if the electrical debondability during or immediately after the voltage application is good. Thus, the separation work cannot be performed. Therefore, it is preferable that the adhesive force recovery rate 30 seconds after the voltage application is stopped is as small as possible.

In the embodiment of the present invention, preferably, the adhesive force of the electrolyte-containing adhesive layer is decreased by the first voltage application step, and the adhesive force recovery rate 30 seconds after the voltage application is stopped is 30% or less.

In addition, preferably, the adhesive force of the electrolyte-containing adhesive layer is decreased by the first voltage application step, and the adhesive force recovery rate 30 minutes after the voltage application is stopped is 40% or more. The adhesive force recovery rate 30 minutes after the voltage application is stopped [(adhesive force after the voltage application to adhesive sheet (30 minutes after the voltage application is stopped) / initial adhesive force) × 100] is preferably 40% or more, more preferably 50% or more, still more preferably 60% or more, and particularly preferably 80% or more. When the adhesive force recovery rate 30 minutes after the voltage application is stopped is 60% or more, the adhesive force is sufficiently recovered in a short period of time after the voltage application is stopped, and the adherend can be allowed to firmly bond again.

The separation step is a step of separating the electrolyte-containing adhesive layer and the adherend.

The separation step may be performed together with the second voltage application step, or may be performed after the second voltage application step. From the viewpoint of safely performing the separation step, the separation step is preferably performed after the second voltage application step.

Separation (debonding) of the adhesive sheet of the present embodiment from the adherend can be performed by generating a potential difference in the thickness direction of the electrolyte-containing adhesive layer by applying a voltage to the electrolyte-containing adhesive layer. For example, when there are adherends having a metal adherend surface on both sides of an adhesive sheet X1 shown in FIG. 1, debonding can be performed by carrying a current to metal adherend surfaces on the both sides and applying a voltage to the electrolyte-containing adhesive layer. When there is an adherend having a metal adherend surface on the electrolyte-containing adhesive layer-side of an adhesive sheet X2 shown in FIG. 3 is an adherend having a metal adherend surface at the electrolyte-containing adhesive layer side, debonding can be performed by carrying a current to the conductive adherend and a conductive layer 4 and applying a voltage to the electrolyte-containing adhesive layer. For an adhesive sheet X3 shown in FIG. 4, debonding can be performed by carrying a current to the conductive layers 4 on the both surfaces and applying a voltage to the electrolyte-containing adhesive layer. The current-carrying is preferably performed by connecting terminals to one end and the other end of the adhesive sheet such that a voltage is applied to the entire electrolyte-containing adhesive layer. The one end and the other end may be a part of the adherend having a metal adherend surface when the adherend has a metal adherend surface. During the debonding, a voltage may be applied after adding water to an interface between the metal adherend surface and the electrolyte-containing adhesive layer.

In the electrolyte-containing adhesive layer separated from the adherend by the separation method for an adherend according to the present embodiment, when a certain period of time (for example, 30 minutes) elapses after the voltage application is stopped, the surface composition of the electrolyte-containing adhesive layer returns to the original state. Thus, the adhesive force can be recovered by allowing a predetermined time to elapse and the adhesive sheet can be again allowed to bond to any adherend.

The separation method for an adherend according to the present embodiment may further include an optional step, and examples of the optional step include a bonding step.

The bonding step is a step of allowing the electrolyte-containing adhesive layer to bond to the conductive adherend and/or a step of allowing the electrolyte-containing adhesive layer to bond to a conductive layer of another adherend including the conductive layer.

[Adhesive Sheet]

(Configuration of adhesive sheet)

The adhesive sheet of the present embodiment is not limited as long as it includes at least one adhesive layer formed of an adhesive composition containing an electrolyte (hereinafter, also referred to as "electrolyte-containing adhesive layer"). The adhesive sheet of the present embodiment may include an adhesive layer free of an electrolyte such as an ionic liquid, in addition to the electrolyte-containing adhesive layer (hereinafter, may be referred to as "another adhesive layer"). In addition to the above, the adhesive sheet of the present embodiment may include a substrate, a conductive layer, a conduction substrate, an intermediate layer, or an undercoat layer. The adhesive sheet of the present embodiment may be, for example, rolled in a roll shape or be in a sheet shape. The "adhesive sheet" shall also include the meaning of "adhesive tape". That is, the adhesive sheet of the present embodiment may be an adhesive tape having a tape-like form.

The adhesive sheet of the present embodiment may be a double-sided adhesive sheet including only the electrolyte-containing adhesive layer without a substrate, that is, a (substrateless) double-sided adhesive sheet including no substrate layer. The adhesive sheet of the present embodiment may be a double-sided adhesive sheet including a substrate, both surfaces of the substrate being the adhesive layer (electrolyte-containing adhesive layer or another adhesive layer). The adhesive sheet of the present embodiment may be a single-sided adhesive sheet including a substrate, only one surface of the substrate being an adhesive layer (electrolyte-containing adhesive layer or another adhesive layer). The adhesive sheet of the present embodiment may include a separator (release liner) for protecting the surface of the adhesive layer, but the separator is not included in the adhesive sheet of the present embodiment.

The structure of the adhesive sheet of the present embodiment is not limited, but examples of the adhesive sheet preferably includes the adhesive sheet X1 shown in FIG. 1 and FIG. 2, the adhesive sheet X2 having a laminate structure shown in FIG. 3 and FIG. 5, and the adhesive sheet X3 having a laminate structure shown in FIG. 4 and FIG. 6.

The adhesive sheet X1 is a substrateless double-sided adhesive sheet including an electrolyte-containing adhesive layer 1 only. The adhesive sheet X2 is a substrate-attached double-sided adhesive sheet having a layer configuration including an adhesive layer 2, a conduction substrate 5 (substrate 3 and conductive layer 4), and the electrolyte-containing adhesive layer 1. The adhesive sheet X3 is a substrate-attached double-sided adhesive sheet having a layer configuration including the adhesive layer 2, the conduction substrate 5 (substrate 3 and conductive layer 4), the electrolyte-containing adhesive layer 1, another conduction substrate 5 (substrate 3 and conductive layer 4), and another adhesive layer 2. In the conduction substrate 5 of the adhesive sheets X2 and X3 shown in FIGs. 3 to 6, the substrate 3 is not essential and only the conductive layer 4 may be present. The adhesive sheet X2 in FIG. 3 may be a single-sided adhesive sheet free of the adhesive layer 2.

FIG. 2 is a sectional configuration diagram illustrating an example of an adhesive sheet adhered body according to the embodiment of the present invention. The adhesive sheet X1 shown in FIG. 2 is a double-sided adhesive sheet including the electrolyte-containing adhesive layer 11 only, and the adhesive sheet adhered body has a laminate structure including a first conductive adherend Y1, an electrolyte-containing adhesive layer 11, and a second conductive adherend Y2. The first conductive adherend Y1 and the second conductive adherend Y2 may be substrates.

The separation method in this case is a method (separation step) of: carrying a current to a position $\alpha$ on the first conductive adherend Y1 and a position $\beta$ on the second conductive adherend Y2 as shown in FIG. 2 and applying a voltage via the first conductive adherend Y1 and the second conductive adherend Y2 (first voltage application step) to generate a potential difference in a thickness direction of the electrolyte-containing adhesive layer 11; maintaining the bonding by recovering the adhesive force by allowing a predetermined time to elapse in a state where the electrolyte-containing adhesive layer 11 is allowed to bond to at least one of the first conductive adherend Y1 and the second conductive adherend Y2 (bonding maintenance step), after the first voltage application step; carrying a current to the position $\alpha$ on the first conductive adherend Y1 and the position $\beta$ on the second conductive adherend Y2 and applying a voltage via the first conductive adherend Y1 and the second conductive adherend Y2 (second voltage application step) to generate a potential difference in the thickness direction of the electrolyte-containing adhesive layer 11; and separating at least one of the first conductive adherend Y1 and the second conductive adherend Y2 from the adhesive sheet X1 (electrolyte-containing adhesive layer 11).

In addition, in the bonding maintenance step, the adhesive force may be recovered by allowing a predetermined time to elapse in the state where the electrolyte-containing adhesive layer 11 is allowed to bond to at least one of the

first conductive adherend Y1 and the second conductive adherend Y2. For example, the bonding to the first conductive adherend Y1 may be maintained, and the second conductive adherend Y2 may be separated and another conductive adherend may be allowed to bond. In this case, in the second voltage application step, a current may be carried to the first conductive adherend Y1 and another conductive adherend, and a voltage may be applied via the first conductive adherend Y1 and another conductive adherend (second voltage application step).

In the first voltage application step and the second voltage application step, a negative electrode may be connected to the portion α on the first conductive adherend Y1 and a positive electrode may be connected to the portion β on the second conductive adherend Y2, or a positive electrode may be connected to the portion α on the first conductive adherend Y1 and a negative electrode may be connected to the portion β on the second conductive adherend Y2.

The positive and negative electrodes connected in the first voltage application step and the second voltage application step can be changed. For example, in the first voltage application step, a negative electrode may be connected to the position α on the first conductive adherend Y1 and a positive electrode may be connected to the position β on the second conductive adherend Y2, and in the second voltage application step, a positive electrode may be connected to the portion α on the first conductive adherend Y1 and a negative electrode may be connected to the portion β on the second conductive adherend Y2.

Further, after the first voltage application step, the first conductive adherend Y1 may be kept to bond to the electrolyte-containing adhesive layer 11, the second conductive adherend Y2 may be separated from the electrolyte-containing adhesive layer 11 and another conductive adherend may be allowed to bond to the electrolyte-containing adhesive layer 11, and after the positive and negative electrodes are changed and the second voltage application step is performed, the first conductive adherend Y1 may be separated from the electrolyte-containing adhesive layer 11.

In the embodiment of the present invention, the adhesive sheet may have a laminate structure including an electrolyte-containing adhesive layer, a first adhesive layer, and a conductive layer located between the electrolyte-containing adhesive layer and the first adhesive layer and bonding to the electrolyte-containing adhesive layer. The electrolyte-containing adhesive layer may be allowed to bond to a conductive adherend, and the first adhesive layer may be allowed to bond to another adherend. In the first voltage application step and the second voltage application step, the voltage may be applied to the electrolyte-containing adhesive layer via the conductive layer and the conductive adherend.

One example is a method of carrying a current to the above conductive adherend and the above conductive layer and applying a voltage to the conductive adherend and the conductive layer to generate a potential difference in the thickness direction of the electrolyte-containing adhesive layer and separating at least one of the conductive adherend and another adherend including the conductive layer from the electrolyte-containing adhesive layer. Examples of the bonding method in this case include a method of allowing the above electrolyte-containing adhesive layer to bond to the above conductive adherend and/or a method of allowing the electrolyte-containing adhesive layer to bond to a conductive layer of another adherend including the conductive layer. When separation occurs between another adherend including the conductive layer and the electrolyte-containing adhesive layer, the separation occurs at an interface between the electrolyte-containing adhesive layer and a conductive layer in contact with the electrolyte-containing adhesive layer. Accordingly, another adherend including the conductive layer can be separated from the electrolyte-containing adhesive layer. The conductive adherend and another adherend including the conductive layer separated by the above separation method can be allowed to bond to each other by the above bonding method and can be separated again from each other by the above separation method. The above another adherend may be an adherend having no conductivity (non-conductive adherend). The present embodiment is preferably used when bonding and separating a conductive adherend and an adherend having no conductivity (non-conductive adherend).

FIG. 5 is a sectional configuration diagram illustrating an example of an adhesive sheet adhered body according to another embodiment of the present invention. The adhesive sheet X2 shown in FIG. 5 is a double-sided adhesive sheet having a layer configuration including an electrolyte-free adhesive layer 21 (first adhesive layer), a substrate 31, a conductive layer 32, and an electrolyte-containing adhesive layer 12. The adhesive sheet adhered body has a non-conductive adherend Y3 on one surface of the electrolyte-free adhesive layer 21 and a conductive adherend Y4 on one surface of the electrolyte-containing adhesive layer 12 of the adhesive sheet, and thus has a laminate structure including the non-conductive adherend Y3, the electrolyte-free adhesive layer 21, the substrate 31, the conductive layer 32, the electrolyte-containing adhesive layer 12, and the conductive adherend Y4. The separation method in this case is a method of: carrying a current to the position α on the conductive layer 32 and the position β on the conductive adherend Y4 as shown in FIG. 5 and applying a voltage via the conductive layer 32 and the conductive adherend Y4 to generate a potential difference in a thickness direction of the electrolyte-containing adhesive layer 12; and separating at least one of the conductive adherend Y4 and the non-conductive adherend Y3 including the conductive layer 32 from the electrolyte-containing adhesive layer 12. In addition, the bonding method in this case is a method of allowing the electrolyte-containing adhesive layer 12 to bond to the conductive adherend Y4, and/or a method of allowing the electrolyte-containing adhesive layer 12 to bond to the conductive layer 32 on the non-conductive adherend Y3 side (non-conductive adherend Y3/electrolyte-free adhesive layer 21/substrate 31/conductive layer 32). When separation occurs on the non-conductive adherend Y3 side, the separation occurs at an interface between the conductive layer 32 and the electrolyte-containing adhesive layer 12. Accordingly, the electrolyte-containing adhesive layer 12 and the non-conductive adherend Y3 side can be separated from each other. In FIG. 5, the substrate 31 and the conductive layer 32 form an integrated conduction substrate 30.

In another embodiment of the present invention, in an adhesive sheet having a laminate structure including a first adhesive layer, an electrolyte-containing adhesive layer, a second adhesive layer, a first conductive layer located between the first adhesive layer and the electrolyte-containing adhesive layer and bonding to the electrolyte-containing adhesive layer, and a second conductive layer located between the second adhesive layer and the electrolyte-containing adhesive layer and bonding to the electrolyte-containing adhesive layer, the first adhesive layer may be adhered to a first adherend and the second adhesive layer may be adhered to a second adherend, and then a voltage may be applied to the electrolyte-containing adhesive layer via the first conductive layer and the second conductive layer to separate at least one of the first adherend including the first conductive layer and the second adherend including the second conductive layer from the electrolyte-containing adhesive layer.

The first adhesive layer and the second adhesive layer may be the same as or different from each other, and may be an electrolyte-containing adhesive layer or an electrolyte-free adhesive layer. The first conductive layer and the second conductive layer may be the same as or different from each other, and are conductive layers to be described later. The first adherend and the second adherend may be the same as or different from each other, and are adherends to be described later.

Another embodiment of the present invention is for example, a method of carrying a current to the above first conductive layer and the above second conductive layer and applying a voltage to the first conductive layer and the second conductive layer to generate a potential difference in the thickness direction of the above electrolyte-containing adhesive layer and separating at least one of the first adherend including the first conductive layer and the second adherend including the second conductive layer from the electrolyte-containing adhesive layer. Examples of the bonding method in this case include a method of allowing the electrolyte-containing adhesive layer to bond to a first conductive layer surface of the first adherend including the first conductive layer and/or a method of allowing the electrolyte-containing adhesive layer to bond to a second conductive layer surface of the second adherend including the second conductive layer. When separation occurs between the first adherend and the electrolyte-containing adhesive layer, the separation occurs at the interface between the electrolyte-containing adhesive layer and the first conductive layer in contact with the electrolyte-containing adhesive layer.

In addition, when separation occurs between the second adherend and the electrolyte-containing adhesive layer, the separation occurs at the interface between the electrolyte-containing adhesive layer and the second conductive layer in contact with the electrolyte-containing adhesive layer. Accordingly, at least one of the first adherend including the first conductive layer and the second adherend including the second conductive layer can be separated from the electrolyte-containing adhesive layer. The first adherend including the first conductive layer and the second adherend including the second conductive layer separated by the above separation method can be allowed to bond to each other by the above bonding method and can be separated from each other again by the above separation method. Both of the first adherend and the second adherend may be an adherend having no conductivity (non-conductive adherend). In the present embodiment, the first adherend and the second adherend are preferably used when non-conductive adherends bond and separate.

FIG. 6 is a sectional configuration diagram illustrating an example of an adhesive sheet adhered body according to an embodiment of the present invention. The adhesive sheet X3 shown in FIG. 6 is a double-sided adhesive sheet having a layer configuration including a electrolyte-free adhesive layer 23 (second adhesive layer), a substrate 51, a conductive layer 52, an electrolyte-containing adhesive layer 13, a conductive layer 42, a substrate 41, and an electrolyte-free adhesive layer 22 (first adhesive layer). The adhesive sheet adhered body has a non-conductive adherend Y5 on one surface of the electrolyte-free adhesive layer 23 and a non-conductive adherend Y6 on one surface of the electrolyte-free adhesive layer 22 of the adhesive sheet, and thus has a laminate structure including the non-conductive adherend Y5, the electrolyte-free adhesive layer 23, the substrate 51, the conductive layer 52, the electrolyte-containing adhesive layer 13, the conductive layer 42, the substrate 41, the electrolyte-free adhesive layer 22, and the non-conductive adherend Y6.

The separation method in this case is a method of: carrying a current to the position $\alpha$ on the conductive layer 52 and the position $\beta$ on the conductive layer 42 as shown in FIG. 6 and applying a voltage via the conductive layer 52 and the conductive layer 42 to generate a potential difference in a thickness direction of the electrolyte-containing adhesive layer 13; and separating at least one of the non-conductive adherend Y5 including the conductive layer 52 and the non-conductive adherend Y6 including the conductive layer 42 from the electrolyte-containing adhesive layer 13. In addition, the bonding method in this case is a method of allowing the electrolyte-containing adhesive layer 13 to bond to the conductive layer 52 on the non-conductive adherend Y5 side (non-conductive adherend Y5/electrolyte-free adhesive layer 23/substrate 51/conductive layer 52), and/or a method of allowing the electrolyte-containing adhesive layer 13 to bond to the conductive layer 42 on the non-conductive adherend Y6 side (non-conductive adherend Y6/electrolyte-free adhesive layer 22/substrate 41/conductive layer 42).

When separation occurs on the non-conductive adherend Y5 side, the separation occurs at the interface between the conductive layer 52 and the electrolyte-containing adhesive layer 13. When separation occurs on the non-conductive adherend Y6 side, the separation occurs at the interface between the conductive layer 42 and the electrolyte-containing adhesive layer 13. Accordingly, at least one of the non-conductive adherend Y5 side and the non-conductive adherend Y6 side can be separated from the electrolyte-containing adhesive layer 13. In FIG. 6, the substrate 51 and the conductive layer 52 form an integrated conduction substrate 50, and the substrate 41 and the conductive layer 42 form an integrated conduction substrate 40.

In the above adhesive sheet adhered body, the adhesive sheet and at least one adherend are bonded to each other via the electrolyte-containing adhesive layer of the adhesive sheet. Preferred examples of the above adhesive sheet adhered body include an adhered body having a laminate structure of first conductive adherend/electrolyte-containing adhesive layer/second conductive adherend (for example, the adhesive sheet adhered body shown in FIG. 2), an adhered body having a laminate structure of non-conductive adherend/electrolyte-free adhesive layer/substrate/electrolyte-containing adhesive layer/conductive adherend (for example, the adhesive sheet adhered body shown in FIG. 5), and an adhered body having a laminate structure of non-conductive adherend/electrolyte-free adhesive layer/substrate/conductive layer/electrolyte-containing adhesive layer/conductive layer/substrate/electrolyte-free adhesive layer/non-conductive adherend (for example, the adhesive sheet adhered body shown in FIG. 6).

Examples of the above adherend include a conductive adherend that conducts electricity and a non-conductive adherend that does not conduct electricity. The conductive adherend is not limited as long as it has conductivity, but examples thereof include sheet-shaped metal (for example, aluminum, copper, iron, tin, gold, silver, or lead as a main component) parts and plates. Examples of the non-conductive adherend is not limited as long as it has no conductivity, but examples thereof include a fiber sheet such as paper, cloth and nonwoven fabric, films or sheets made of various plastics (a polyolefin-based resin such as polyethylene and polypropylene, a polyester-based resin such as polyethylene terephthalate, an acrylic resin such as polymethyl methacrylate, and the like), and a laminate thereof. The thickness of the adherend is not limited, but is preferably 0.1 mm or more and 100 mm or less. The upper limit of the thickness is more preferably 50 mm, and still more preferably 30 mm, and the lower limit of the thickness is more preferably 0.3 mm, and still more preferably 1 mm.

The thickness of the above adhesive sheet adhered body in the present invention is not limited, but is preferably 0.1 mm or more and 300 mm or less. The upper limit of the thickness is more preferably 200 mm, still more preferably 100 mm, and particularly preferably 50 mm, and the lower limit of the thickness is more preferably 0.2 mm, still more preferably 0.3 mm, and particularly preferably 0.5 mm.

The substrate 3, 31, 41, 51 is not limited, but examples thereof include a paper-based substrate such as paper, a fiber-based substrate such as cloth and nonwoven fabric, a plastic substrate such as a film or sheet made of various plastics (a polyolefin-based resin such as polyethylene and polypropylene, a polyester-based resin such as polyethylene terephthalate, an acrylic resin such as polymethyl methacrylate, and the like), and a laminate thereof. The substrate may have a form of a single layer and may have a form of multi-layers. The substrate may be subjected to, if necessary, various treatments such as a back-face treatment, an antistatic treatment, and an undercoating treatment.

The conductive layer 4, 32, 42, 52 is not limited so long as it is a layer having conductivity, but may be a metal-based substrate such as a metal foil (for example, aluminum, magnesium, copper, iron, tin, and gold) and a metal plate (for example, aluminum, magnesium, copper, iron, tin, and silver), a conductive polymer, and the like. The conductive layer may be a metal-deposited film provided on the substrate 3, 31, 41, 51.

The conduction substrate 5, 30, 40, 50 is not limited so long as it is a substrate having a conductive layer (carrying a current), but examples thereof include a substrate having a metal layer formed on a surface thereof. Examples of the substrate include a substrate having a metal layer formed on a surface of the substrate exemplified above by a method such as a plating method, a chemical vapor deposition method or sputtering. Examples of the metal layer include the metal, metal plate and conductive polymer exemplified above. The conduction substrate 5, 30, 40, 50 may be an adhesive tape having a tape-like form.

It is preferred in the adhesive sheet X1 shown in FIG. 1 that the adherend at the both sides thereof is an adherend having a metal adherend surface. It is preferred in the adhesive sheet X2 shown in FIG. 3 that the adherend at the electrolyte-containing adhesive layer 1 side is an adherend having a metal adherend surface.

Examples of the metal adherend surface include a surface having conductivity and composed of a metal containing, for example, aluminum, copper, iron, magnesium, tin, gold, silver or lead as a main component. Among these, the surface composed of a metal containing aluminum is preferred. Examples of the adherend having a metal adherend surface include a sheet, a component, or a plate that is composed of a metal containing, for example, aluminum, copper, iron, magnesium, tin, gold, silver or lead as a main component. An adherend other than the adherend having a metal adherend surface is not limited, but examples thereof include a fiber sheet such as paper, cloth or nonwoven fabric, and a film or a sheet of various plastics.

The thickness of the electrolyte-containing adhesive layer 1 is preferably 1 μm or more and 1,000 μm or less

from the viewpoint of the initial adhesive force. The upper limit of the thickness of the electrolyte-containing adhesive layer 1 is more preferably 500 μm, still more preferably 100 μm and particularly preferably 30 μm, and lower limit thereof is more preferably 3 μm, still more preferably 5 μm and particularly preferably 8 μm. When the adhesive sheet is a substrateless double-sided adhesive sheet including only the electrolyte-containing adhesive layer (adhesive sheet X1 shown in FIG. 1), the thickness of the electrolyte-containing adhesive layer is a thickness of the adhesive sheet.

The thickness of the adhesive layer 2 is preferably 1 μm or more and 2000 μm or less from the viewpoint of adhesive force. The upper limit of the thickness of the adhesive layer 2 is more preferably 1,000 μm, still more preferably 500 μm and particularly preferably 100 μm, and the lower limit thereof is more preferably 3 μm, still more preferably 5 μm and particularly preferably 8 μm.

The thickness of the substrate 3 is preferably 10 μm or more and 1,000 μm or less. The upper limit of the thickness is more preferably 500 μm, still more preferably 300 μm and particularly preferably 100 μm, and the lower limit thereof is more preferably 12 μm and still more preferably 25 μm.

The thickness of the conductive layer 4 is preferably 0.001 μm or more and 1,000 μm or less. The upper limit of the thickness is more preferably 500 μm, still preferably 300 μm, still more preferably 50 μm and still more preferably 10 μm, and the lower limit thereof is more preferably 0.01 μm, still more preferably 0.03 μm and still more preferably 0.05 μm.

The thickness of the conduction substrate 5 is preferably 10 μm or more and 1,000 μm or less. The upper limit of the thickness is more preferably 500 μm, still more preferably 300 μm and particularly preferably 100 μm, and the lower limit thereof is more preferably 12 μm and still more preferably 25 μm.

The surfaces of the electrolyte-containing adhesive layer of the adhesive sheet of the present embodiment and another adhesive layer may be protected by a separator (release liner). The separator is not limited, but examples thereof include a release liner in which the surface of a substrate (liner substrate) such as paper or plastic film has been silicone-treated, and a release liner in which the surface of a substrate (liner substrate) such as paper or plastic film has been laminated with a polyolefin-based resin. The thickness of the separator is not limited, but is preferably 10 μm or more and 100 μm or less.

The thickness of the adhesive sheet of the present embodiment is preferably 20 μm or more and 3,000 μm or less. The upper limit of the thickness is more preferably 1,000 μm, still more preferably 300 μm and particularly preferably 200 μm, and the lower limit thereof is more preferably 30 μm and still more preferably 50 μm.

In particular, for the adhesive sheet X2 shown in FIG. 3, the thickness of the adhesive sheet is preferably 50 μm or more and 2,000 μm or less. The upper limit of the thickness is more preferably 1,000 μm and still more preferably 200 μm, and the lower limit thereof is more preferably 80 μm and still more preferably 100 μm.

In particular, for the adhesive sheet X3 shown in FIG. 4, the thickness of the adhesive sheet is preferably 100 μm or more and 3,000 μm or less. The upper limit of the thickness is more preferably 1,000 μm and still more preferably 300 μm, and the lower limit thereof is more preferably 150 μm and still more preferably 200 μm.

(Electrolyte-containing adhesive layer)

The electrolyte-containing adhesive layer contains at least a polymer as an adhesive composition for forming the electrolyte-containing adhesive layer, and an electrolyte.

The electrolyte-containing adhesive layer preferably has a water content of 0.4% or more after being stored in an environment of 23°C and 50% for 3 days.

Electrical debonding requires cations and/or anions of the ionic liquid in the electrolyte-containing adhesive layer to move to an interface with the conductive layer or the conductive adherend connected to the negative electrode or the positive electrode. Thus, the higher polarity of the electrolyte-containing adhesive layer equates to the easier movement of the ionic liquid, and the electrical debondability is good. Since the polarity increases as the water content of the electrolyte-containing adhesive layer increases, the water content of the electrolyte-containing adhesive layer is preferably 0.4% or more.

The water content of the electrolyte-containing adhesive layer can be determined by, for example, leaving the electrolyte-containing adhesive layer in an environment of 23°C and 50% RH for 3 days, then measuring the water content by the Karl Fischer water vaporization-coulometric titration method (JIS K 0113:2005), and using the following equation. Specifically, the water content can be determined by the method described in Examples.

$$\text{Water content (\%)} = (\text{water amount measured by Karl Fischer / total sample mass before measurement}) \times 100$$

(Polymer)

The adhesive composition of the present embodiment contains a polymer. In the present embodiment, the polymer is not limited as long as the polymer is a general organic polymer compound, and examples thereof include a polymerized product or a partially polymerized product of monomers. The monomers may be one kind of monomers and may be a monomer mixture of two or more kinds of monomers. The partially polymerized product means a polymerized product in which the monomer or at least a part of the monomer mixture is partially polymerized.

The polymer in the present embodiment is not limited as long as the polymer is used as a general adhesive and has adhesiveness, and examples thereof include an acrylic polymer, a rubber-based polymer, a vinyl alkyl ether-based polymer, a silicone-based polymer, a polyester-based polymer, a polyamide-based polymer, a urethane-based polymer, a fluorine-based polymer, and an epoxy-based polymer. The polymer can be used alone or a combination of two or more kinds thereof may be used may be used.

The polymer in the present embodiment preferably contains at least one selected from the group consisting of a polyester-based polymer and an acrylic polymer having a carboxyl group and/or a hydroxy group. The total content of the polyester-based polymer and the acrylic polymer having a carboxyl group and/or a hydroxy group in the polymer of the present embodiment is preferably 60% by mass or more, and more preferably 80% by mass or more.

In particular, in order to reduce the cost and increase productivity, and initial adhesive force, the polymer in the present embodiment is preferably an acrylic polymer.

That is, the adhesive composition of the present embodiment is preferably an acrylic adhesive composition containing an acrylic polymer as a polymer.

The acrylic polymer preferably has a monomer unit derived from an alkyl (meth)acrylate (the following Formula (1)) having an alkyl group having 1 to 14 carbon atoms. Such a monomer unit is suitable for obtaining large initial adhesive force. Further, for improving the electrical debondability, the alkyl group $R^b$ in the following Formula (1) preferably has a small amount of carbon atoms, particularly preferably 8 or less carbon atoms, and more preferably 4 or less carbon atoms.

$$CH_2=C(R^a)COOR^b \qquad (1)$$

[In the Formula (1), $R^a$ is a hydrogen atom or a methyl group, and $R^b$ is an alkyl group having 1 to 14 carbon atoms].

Examples of the alkyl (meth)acrylate having an alkyl group having 1 to 14 carbon atoms include methyl (meth)acrylate, ethyl (meth)acrylate, propyl (meth)acrylate, isopropyl (meth)acrylate, n-butyl (meth)acrylate, sec-butyl (meth)acrylate, 1,3-dimethylbutyl acrylate, pentyl (meth)acrylate, isopentyl (meth)acrylate, hexyl (meth)acrylate, 2-ethyl butyl (meth)acrylate, heptyl (meth)acrylate, n-octyl (meth)acrylate, isooctyl (meth)acrylate, 2-ethylhexyl (meth)acrylate, n-nonyl (meth)acrylate, isononyl (meth)acrylate, n-decyl (meth)acrylate, isodecyl (meth)acrylate, n-dodecyl (meth)acrylate, n-tridecyl (meth)acrylate, and n-tetradecyl (meth)acrylate. Among these, n-butyl acrylate, 2-ethylhexyl acrylate, and isononyl acrylate are preferred. The alkyl (meth)acrylate having an alkyl group having 1 to 14 carbon atoms can be used alone or a combination of two or more kinds thereof may be used.

The proportion of the alkyl (meth)acrylate having an alkyl group having 1 to 14 carbon atoms to total monomer components (100% by mass) constituting the acrylic polymer is not limited, but is preferably 70% by mass or more, more preferably 80% by mass or more, and still more preferably 85% by mass or more. 70% by mass or more of the proportion of the acrylic polymer easily allows initial adhesive force to be large.

In addition to the monomer unit derived from the alkyl (meth)acrylate having an alkyl group having 1 to 14 carbon atoms, the acrylic polymer preferably further has a monomer unit derived from a polar group-containing monomer copolymerizable with the monomer unit derived from the alkyl (meth)acrylate having an alkyl group having 1 to 14 carbon atoms, for the purpose of the modification of cohesive force, heat resistance, crosslinking property, and the like. Such a monomer unit is preferable for allowing initial adhesive force to be large because the monomer can impart a crosslinking point. Further, also from the viewpoint of improving the electrical debondability, the acrylic polymer preferably includes a monomer unit derived from a polar group-containing monomer.

Examples of the polar group-containing monomer include a carboxyl group-containing monomer, a hydroxy group-containing monomer, a cyano group-containing monomer, a vinyl group-containing monomer, an aromatic vinyl monomer, an amide group-containing monomer, an imide group-containing monomer, an amino group-containing monomer, an epoxy group-containing monomer, a vinyl ether monomer, an N-acryloyl morpholine, a sulfo group-containing monomer, a phosphate group-containing monomer, and an acid anhydride group-containing monomer. Among these, from the viewpoint of excellent cohesiveness, a carboxyl group-containing monomer, a hydroxy group-containing monomer, and an amide group-containing monomer are preferred, and a carboxyl group-containing monomer is particularly preferred. A carboxyl group-containing monomer is particularly preferable for allowing initial adhesive force to be large. The polar group-containing monomer can be used alone or a combination of two or more kinds thereof may be used.

Examples of the carboxyl group-containing monomer include acrylic acid, methacrylic acid, carboxyethyl (meth)acrylate, carboxypentyl (meth)acrylate, itaconic acid, maleic acid, fumaric acid, crotonic acid, and isocrotonic acid. Acrylic acid is particularly preferred. The carboxyl group-containing monomer can be used alone or a combination of two or more kinds thereof may be used.

Examples of the hydroxy group-containing monomer include 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, (4-hydroxymethylcyclohexyl)methyl (meth)acrylate, N-methylol (meth)acrylamide, vinyl alcohol, allyl alcohol, 2-hydroxyethyl vinyl ether, 4-hydroxybutyl vinyl ether, and diethylene glycol monovinyl ether. 2-hydroxyethyl (meth)acrylate and 4-hydroxybutyl (meth)acrylate are particularly preferred. The hydroxy group-containing monomer can be used alone or a combination of two or more kinds thereof may be used.

Examples of the amide group-containing monomer include acrylamide, methacrylamide, N-vinyl pyrrolidone, N,N-dimethylacrylamide, N,N-dimethyl methacrylamide, N,N-diethylacrylamide, N,N-diethyl methacrylamide, N,N'-methylenebisacrylamide, N,N-dimethylaminopropyl acrylamide, N,N-dimethylaminopropyl methacrylamide, and diacetone acrylamide. The amide group-containing monomer can be used alone or a combination of two or more kinds thereof may be used.

Examples of the cyano group-containing monomer include acrylonitrile and methacrylonitrile.

Examples of the vinyl group-containing monomer include vinyl esters such as vinyl acetate, vinyl propionate, and vinyl laurate. Vinyl acetate is particularly preferred.

Examples of the aromatic vinyl monomer include styrene, chlorostyrene, chloromethylstyrene, $\alpha$-methyl styrene, and other substituted styrene.

Examples of the imide group-containing monomer include cyclohexyl maleimide, isopropyl maleimide, N-cyclohexyl maleimide, and itaconimide.

Examples of the amino group-containing monomer include aminoethyl (meth)acrylate, N,N-dimethylaminoethyl (meth)acrylate, and N,N-dimethylaminopropyl (meth)acrylate.

Examples of the epoxy group-containing monomer include glycidyl (meth)acrylate, methylglycidyl (meth)acrylate, and allyl glycidyl ether.

Examples of the vinyl ether monomer include methyl vinyl ether, ethyl vinyl ether, and isobutyl vinyl ether.

The proportion of the polar group-containing monomer to total monomer components (100% by mass) constituting the acrylic polymer is preferably 0.1% by mass or more and 35% by mass or less. The upper limit of the proportion of the polar group-containing monomer is more preferably 25% by mass, and still more preferably 20% by mass. The lower limit of the proportion is more preferably 0.5% by mass, still more preferably 1% by mass, and particularly preferably 2% by mass. When the proportion of the polar group-containing monomer is 0.1% by mass or more, cohesive force is easy to be obtained. Thus, adhesive residue is less likely to occur on the surface of an adherend after debonding the adhesive layer, and the electrical debondability is improved. In addition, when the proportion of the polar group-containing monomer is 30% by mass or less, the adhesive layer is easy to be prevented from excessively adhering to the adherend and becoming a heavy debonding type. In particular, when the proportion is 2% by mass or more and 20% by mass or less, both debondability to the adherend and adhesion between the surface of the adhesive layer and another layer are easy to be achieved.

The monomer components constituting the acrylic polymer may contain a polyfunctional monomer, for introducing a crosslinked structure into the acrylic polymer and allowing for easily obtaining necessary cohesive force.

Examples of the polyfunctional monomer include ethylene glycol di(meth)acrylate, diethylene glycol di(meth)acrylate, tetraethylene glycol di(meth)acrylate, neopentyl glycol di(meth)acrylate, 1,6-hexanediol di(meth)acrylate, trimethylolpropane tri(meth)acrylate, pentaerythritol tri(meth)acrylate, dipentaerythritol hexa(meth)acrylate, divinylbenzene, and N,N'-methylene bisacrylamide. The polyfunctional monomer can be used alone or a combination of two or more kinds thereof may be used.

The content of the polyfunctional monomer to total monomer components (100% by mass) constituting the acrylic polymer is preferably 0.1% by mass or more and 15% by mass or less. The upper limit of the content of the polyfunctional monomer is more preferably 10% by mass, and the lower limit thereof is more preferably 3% by mass. 0.1% by mass or more of the content of the polyfunctional monomer is preferable as flexibility and adhesiveness of the adhesive layer are easy to be improved. When the content of the polyfunctional monomer is 15% by mass or less, the cohesive force is not excessively high, and appropriate adhesiveness is easy to be obtained.

The polyester-based polymer is typically a polymer having a structure in which a polycarboxylic acid such as a dicarboxylic acid or a derivative thereof (hereinafter also referred to as "polycarboxylic acid monomer") is condensed with a polyhydric alcohol such as a diol or a derivative thereof (hereinafter also referred to as "polyhydric alcohol monomer").

The polycarboxylic acid monomer is not limited, but examples thereof include adipic acid, azelaic acid, dimer acid, sebacic acid, 1,4-cyclohexanedicarboxylic acid, 1,3-cyclohexanedicarboxylic acid, 1,2-cyclohexanedicarboxylic acid, 4-methyl-1,2-cyclohexanedicarboxylic acid, dodecenyl succinic anhydride, fumaric acid, succinic acid, dodecanedioic acid, hexahydrophthalic anhydride, tetrahydrophthalic anhydride, maleic acid, maleic anhydride, itaconic acid, citraconic acid, and a derivative thereof.

The polycarboxylic acid monomer can be used alone or a combination of two or more kinds thereof may be used.

The polyhydric alcohol monomer is not limited, but examples thereof include ethylene glycol, 1,2-propylene glycol, 1,3-propanediol, 2-methyl-1,3-propanediol, 1,2-butanediol, 1,3-butanediol, 1,4-butanediol, 1,5-pentanediol, 1,6-hexanediol, 3-methyl-1,5-pentanediol, neopentyl glycol, diethylene glycol, dipropylene glycol, 2,2,4-trimethyl-1,5-pentanediol, 2-ethyl-2-butylpropanediol, 1,9-nonanediol, 2-methyloctanediol, 1,10-decanediol, a derivative thereof.

The polyhydric alcohol monomer can be used alone or a combination of two or more kinds thereof may be used.

Moreover, the polymer in the present embodiment may contain an ionic polymer. The ionic polymer is a polymer having an ionic functional group. When the polymer contains an ionic polymer, the relative permittivity of the polymer is increased and the electrical debondability is improved. When the polymer contains an ionic polymer, the content of the ionic polymer is preferably 0.05 parts by mass or more and 2 parts by mass or less, per 100 parts by mass of the polymer.

The polymer in the present embodiment can be obtained by (co)polymerizing the monomer components. The polymerization method is not limited, but examples thereof include solution polymerization, emulsion polymerization, bulk polymerization, suspension polymerization, and photopolymerization (active energy ray polymerization). The solution polymerization is preferred from the viewpoint of costs and productivity. When the monomer components have been copolymerized, the resulting copolymer may be any of a random copolymer, a block copolymer, an alternating copolymer, a graft copolymer and the like.

The solution polymerization is not limited, but examples thereof include a method in which monomer components, a polymerization initiator, and the like are dissolved in a solvent, and the resultant one is heated and polymerized to obtain a polymer solution containing a polymer.

As the solvent used in the solution polymerization, various common solvents can be used. Examples of such solvents (polymerization solvents) include organic solvents, for example, aromatic hydrocarbons such as toluene, benzene, and xylene; esters such as ethyl acetate and n-butyl acetate; aliphatic hydrocarbons such as n-hexane and n-heptane; alicyclic hydrocarbons such as cyclohexane and methyl cyclohexane; and ketones such as methyl ethyl ketone and methyl isobutyl ketone. The solvent can be used alone or a combination of two or more kinds thereof may be used.

The amount of the solvent to be used is not limited, but is preferably 10 parts by mass or more and 1000 parts by mass or less to total monomer components (100 parts by mass) constituting the polymer. The upper limit of the amount of the solvent to be used is more preferably 500 parts by mass and the lower limit thereof is more preferably 50 parts by mass.

The polymerization initiator to be used in the solution polymerization is not limited, but examples thereof include a peroxide-based polymerization initiator and an azo-based polymerization initiator. The peroxide-based polymerization initiator is not limited, but examples thereof include a peroxycarbonate, a ketone peroxide, a peroxy ketal, a hydroperoxide, a dialkyl peroxide, a diacyl peroxide, and a peroxy ester, and more specific examples thereof include benzoyl peroxide, t-butyl hydroperoxide, di-t-butyl peroxide, t-butyl peroxybenzoate, dicumyl peroxide, 1,1-bis(t-butylperoxy)-3,3,5-trimethylcyclohexane, and 1,1-bis(t-butylperoxy)cyclododecane. The azo-based polymerization initiator is not limited, but examples thereof include 2,2'-azobisisobutyronitrile, 2,2'-azobis-2-methylbutyronitrile, 2,2'-azobis(2,4-dimethylvaleronitrile), 2,2'-azobis(2-methylpropionic acid)dimethyl, 2,2'-azobis(4-methoxy-2,4-dimethylvaleronitrile), 1,1'-azobis(cyclohexane-1-carbonitrile), 2,2'-azobis(2,4,4-trimethylpentane), 4,4'-azobis-4-cyanovaleric acid, 2,2'-azobis(2-amidinopropane) dihydrochloride, 2,2'-azobis[2-(5-methyl-2-imidazolin-2-yl)propane] dihydrochloride, 2,2'-azobis(2-methylpropionamidine) disulfate, 2,2'-azobis(N,N'-dimethyleneisobutylamidine) hydrochloride, and 2,2'-azobis[N-(2-carboxyethyl)-2-methylpropionamidine] hydrate. The polymerization initiator can be used alone or a combination of two or more kinds thereof may be used.

The amount of the polymerization initiator to be used is not limited, but is preferably 0.01 parts by mass or more and 5 parts by mass or less, to total monomer components (100 parts by mass) constituting the polymer. The upper limit of the amount of the polymerization initiator to be used is more preferably 3 parts by mass, and the lower limit thereof is more preferably 0.05 parts by mass.

The heating temperature in heating and polymerizing in the solution polymerization is not limited, but is, for example, 50°C or higher and 80°C or lower. The heating time is not limited, but is, for example, 1 hour or more and 24 hours or less.

The weight average molecular weight of the polymer is not limited, but is preferably 100,000 or more and 5,000,000 or less. The upper limit of the weight average molecular weight is more preferably 4,000,000 and still more preferably 3,000,000, and the lower limit thereof is more preferably 200,000 and still more preferably 300,000. 100,000 or more of the weight average molecular weight allows the cohesive force to be small, and this can effectively prevent the disadvantage that an adhesive residue remains on the surface of the adherend after debonding the adhesive layer. In addition, 5,000,000 or less of the weight average molecular weight can effectively prevent the disadvantage that wettability of the surface of the adherend after debonding the adhesive layer is insufficient.

The weight average molecular weight is obtained by measuring with a gel permeation chromatography (GPC)

method. More specifically, for example, the weight average molecular weight can be measured using "HLC-8220GPC" (trade name, manufactured by Tosoh Corporation) as a GPC measuring device, under the following conditions and can be calculated from a standard polystyrene conversion value.

(Conditions for measuring weight average molecular weight)

Sample concentration: 0.2% by mass (tetrahydrofuran solution)
Sample injection amount: 10 μL
Sample column: TSK guard column Super HZ-H (1 piece) + TSK gel Super HZM-H (2 pieces)
Reference column: TSK gel Super H-RC (1 piece)
Eluent: tetrahydrofuran (THF)
Flow rate: 0.6 mL/min
Detector: differential refractometer (RI)
Column temperature (measurement temperature): 40°C

The glass transition temperature (Tg) of the polymer is not limited. 0°C or lower of the glass transition temperature is preferable, as this allows for preventing the decrease in initial adhesive force. The glass transition temperature is more preferably -10°C or lower, and still more preferably -20°C or lower. In addition, -40°C or lower the glass transition temperature is particularly preferable, as this allows the rate of decrease in adhesive force by voltage application to be particularly large. The glass transition temperature is most preferably -50°C or lower.

The glass transition temperature (Tg) can be calculated, for example, based on the following formula (Y) (Fox formula).

$$1/Tg = W1/Tg1 + W2 / Tg2 + \ldots + Wn/Tgn \qquad (Y)$$

[In the formula (Y), Tg represents a glass transition temperature (unit: K) of the polymer, Tgi (i=1, 2, ... n) represents a glass transition temperature (unit: K) of the polymer when a homopolymer has been formed of a monomer i, and Wi (i=1, 2, ... n) represents a weight fraction in the total monomer components of the monomer i]

The formula (Y) is a calculation formula in a case where the polymer is formed of n kinds (monomer 1, monomer 2, ... monomer n) of monomer components.

The glass transition temperature when the homopolymer has been formed means a glass transition temperature of a homopolymer of the monomer and means a glass transition temperature (Tg) of a polymer that is formed of only a certain monomer (referred to as "monomer X" in some cases) as the monomer component. Specifically, numerical values are exemplified in "Polymer Handbook" (Third Edition, John Wiley & Sons, Inc, 1989). The glass transition temperature (Tg) of a homopolymer not described in the above-described literature is, for example, a value obtained by the following measuring method. That is, 100 parts by mass of the monomer X, 0.2 parts by mass of 2,2'-azobisisobutyronitrile, and 200 parts by mass of ethyl acetate as a polymerization solvent are charged into a reactor equipped with a thermometer, a stirrer, a nitrogen inlet tube, and a reflux condenser, and are stirred for 1 hour with a nitrogen gas introduced. In this manner, oxygen in a polymerization system is removed, and then, the temperature is raised to 63°C and a reaction is performed for 10 hours. Next, the temperature is cooled to room temperature and thus a homopolymer solution having a solid content concentration of 33% by mass is obtained. Next, the homopolymer solution is coated onto a release liner by flow casting, and dried to prepare a test sample (sheet-shaped homopolymer) having a thickness of approximately 2 mm. Then, approximately 1 to 2 mg of the test sample is weighed into an open cell made of aluminum to measure the behavior of reversing heat flow (specific heat component) of the homopolymer using a temperature-modulated DSC (trade name "Q-2000" manufactured by TA Instruments) at a temperature rising rate of 5°C/min in 50 ml/min of a nitrogen atmosphere. With reference to JIS-K-7121, a temperature at the point where a straight line equidistant in a vertical axis direction from straight lines which are obtained by extending a baseline on a high temperature side and a baseline on the low temperature side of the obtained reversing heat flow, intersects with a curve of a portion in which the glass transition changes stepwise, is set as the glass transition temperature (Tg) when the homopolymer has been formed.

The content of the polymer in the adhesive composition of the present embodiment is preferably 50% by mass or more and 99.9% by mass or less, to the total amount (100% by mass) of the adhesive composition. The upper limit of the content is more preferably 99.5% by mass and still more preferably 99% by mass, and the lower limit thereof is more preferably 60% by mass and still more preferably 70% by mass.

(Electrolyte)

The electrolyte contained in the electrolyte-containing adhesive layer is a substance that can be ionized into anions and cations. Examples of such an electrolyte include an ionic liquid, an alkali metal salt, and an alkaline earth metal salt. An ionic liquid is preferred as the electrolyte contained in the electrolyte-containing adhesive layer from the viewpoint of achieving good electrical debondability in the electrolyte-containing adhesive layer. The ionic liquid is a salt of a liquid at room temperature (about 25°C) and contains anions and cations.

(Ionic liquid)

The ionic liquid in the present embodiment is constituted of a pair of an anion and a cation, and is not limited so long as it is a molten salt that is liquid at 25°C (room temperature molten salt). Examples of the anion and the cation are given below. Among ionic substances obtained by combining the anion and the cation, the one that is liquid at 25°C is an ionic liquid, and the one that is solid at 25°C is not an ionic liquid but an ionic solid described later.

The anion of the ionic liquid includes, for example, $(FSO_2)_2N^-$, $(CF_3SO_2)_2N^-$, $(CF_3CF_2SO_2)_2N^-$, $(CF_3SO_2)_3C^-$, $Br^-$, $AlCl_4^-$, $Al_2Cl_7^-$, $NO_3^-$, $BF_4^-$, $PF_6^-$, $CH_3COO^-$, $CF_3COO^-$, $CF_3CF_2CF_2COO^-$, $CF_3SO_3^-$, $CF_3(CF_2)_3SO_3^-$, $AsF_6^-$, $SbF_6^-$, and $F(HF)_n^-$. Among these, anions of a sulfonyl imide-based compound such as $(FSO_2)_2N^-$ [bis(fluorosulfonyl)imide an ion] or $(CF_3SO_2)_2N^-$ [bis(trifluoromethanesulfonyl)imide anion] are preferred as the anion since the anions are chemically stable and suitable in improving the electrical debondability.

As the cation in the ionic liquid, nitrogen-containing onium, sulfur-containing onium and phosphorus-containing onium cations are preferred as they are chemically stable and suitable in improving the electrical debondability. Imidazolium-based cations, ammonium-based cations, pyrrolidinium-based cations and pyridinium-based cations are more preferred.

Examples of the imidazolium-based cation include 1-methylimidazolium cation, 1-ethyl-3-methylimidazolium cation, 1-propyl-3-methylimidazolium cation, 1-butyl-3-methylimidazolium cation, 1-pentyl-3-methylimidazolium cation, 1-hexyl-3-methylimidazolium cation, 1-heptyl-3-methylimidazolium cation, 1-octyl-3-methylimidazolium cation, 1-nonyl-3-methylimidazolium cation, 1-undecyl-3-methylimidazolium cation, 1-dodecyl-3-methylimidazolium cation, 1-tridecyl-3-methylimidazolium cation, 1-tetradecyl-3-methylimidazolium cation, 1-pentadecyl-3-methylimidazolium cation, 1-hexadecyl-3-methylimidazolium cation, 1-heptadecyl-3-methylimidazolium cation, 1-octadecyl-3-methylimidazolium cation, 1-undecyl-3-methylimidazolium cation, 1-benzyl-3-methylimidazolium cation, 1-butyl-2,3-dimethylimidazolium cation, and 1,3-bis(dodecyl)imidazolium cation.

Examples of the pyridinium-based cation include 1-butylpyridinium cation, 1-hexylpyridinium cation, 1-butyl-3-methylpyridinium cation, 1-butyl-4-methylpyridinium cation, and 1-octyl-4-methylpyridinium cation.

Examples of the pyrrolidinium-based cation include 1-ethyl-1-methylpyrrolidinium cation, and 1-butyl-1-methylpyrrolidinium cation.

Examples of the ammonium-based cation include tetraethylammonium cation, tetrabutylammonium cation, methyltrioctylammonium cation, tetradecytrihexylammonium cation, glycidyltrimethylammonium cation, and trimethylaminoethyl acrylate cation.

As the ionic liquid, it is preferable to select a cation having a molecular weight of 160 or less as the constituent cation, from the viewpoint of increasing the rate of decrease in adhesive force during voltage application. The ionic liquid containing the above-described $(FSO_2)_2N^-$ [bis(fluorosulfonyl)imide anion] or $(CF_3SO_2)_2N^-$ [bis(trifluoromethanesulfonyl)imide anion] and a cation having a molecular weight of 160 or less is particularly preferred. Examples of the cation having a molecular weight of 160 or less include 1-methylimidazolium cation, 1-ethyl-3-methylimidazolium cation, 1-propyl-3-methylimidazolium cation, 1-butyl-3-methylimidazolium cation, 1-pentyl-3-methylimidazolium cation, 1-butylpyridinium cation, 1-hexylpyridinium cation, 1-butyl-3-methylpyridinium cation, 1-butyl-4-methylpyridinium cation, 1-ethyl-1-methylpyrrolidinium cation, 1-butyl-1-methylpyrrolidinium cation, tetraethylammonium cation, glycidyltrimethylammonium cation, and trimethylaminoethyl acrylate cation.

The cations represented by the following Formulas (2-A) to (2-D) are preferred as the cation in the ionic liquid.

[Chem. 1]

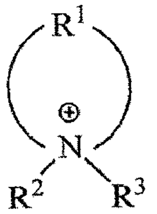

(2-A)

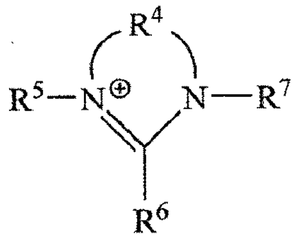

(2-B)

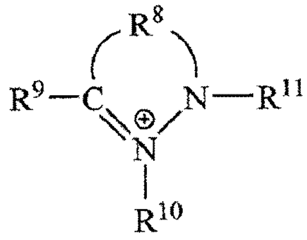

(2-C)

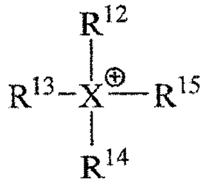

(2-D)

In the Formula (2-A), $R^1$ represents a hydrocarbon group having 4 to 10 carbon atoms (preferably a hydrocarbon group having 4 to 8 carbon atoms and more preferably a hydrocarbon group having 4 to 6 carbon atoms) and may contain a hetero atom, $R^2$ and $R^3$ may be the same or different, represent a hydrogen atom or a hydrocarbon group having 1 to 12 carbon atoms (preferably a hydrocarbon group having 1 to 8 carbon atoms, more preferably a hydrocarbon group having 2 to 6 carbon atoms, and still more preferably a hydrocarbon group having 2 to 4 carbon atoms), and may contain a hetero atom. When a nitrogen atom forms a double bond with an adjacent carbon atom, $R^3$ is not present.

In the Formula (2-B), $R^4$ represents a hydrocarbon group having 2 to 10 carbon atoms (preferably a hydrocarbon group having 2 to 8 carbon atoms and more preferably a hydrocarbon group having 2 to 6 carbon atoms) and may contain a hetero atom, and $R^5$, $R^6$, and $R^7$ may be the same or different, represent a hydrogen atom or a hydrocarbon group having 1 to 12 carbon atoms (preferably a hydrocarbon group having 1 to 8 carbon atoms, more preferably a hydrocarbon group having 2 to 6 carbon atoms, and still more preferably a hydrocarbon group having 2 to 4 carbon atoms), and may contain a hetero atom.

In the Formula (2-C), $R^8$ represents a hydrocarbon group having 2 to 10 carbon atoms (preferably a hydrocarbon group having 2 to 8 carbon atoms and more preferably a hydrocarbon group having 2 to 6 carbon atoms) and may contain a hetero atom, and $R^9$, $R^{10}$, and $R^{11}$ may be the same or different, represent a hydrogen atom or a hydrocarbon group having 1 to 16 carbon atoms (preferably a hydrocarbon group having 1 to 10 carbon atoms and more preferably a hydrocarbon group having 1 to 8 carbon atoms), and may contain a hetero atom.

In the Formula (2-D), X represents a nitrogen atom, a sulfur atom or a phosphorus atom, and $R^{12}$, $R^{13}$, $R^{14}$, and $R^{15}$ may be the same or different, represent a hydrocarbon group having 1 to 16 carbon atoms (preferably a hydrocarbon group having 1 to 14 carbon atoms, more preferably a hydrocarbon group having 1 to 10 carbon atoms, still more preferably a hydrocarbon group having 1 to 8 carbon atoms, and particularly preferably a hydrocarbon group having 1 to 6 carbon atoms), and may contain a hetero atom. When X is a sulfur atom, $R^{12}$ is not present.

The molecular weight of the cation in the ionic liquid is, for example, 500 or less, preferably 400 or less, more preferably 300 or less, still more preferably 250 or less, particularly preferably 200 or less, and most preferably 160 or less. In addition, the molecular weight is typically 50 or more. It is considered that the cation in the ionic liquid has the property to move to a cathode side in the electrolyte-containing adhesive layer during voltage application and deviate to the vicinity of the interface between the electrolyte-containing adhesive layer and the adherend. Thus, in the present invention, the adhesive force during voltage application is decreased as compared with the initial adhesive force, and the electrical debondability occurs. The cation having a small molecular weight of 500 or less is further easy to move to the cathode side in the electrolyte-containing adhesive layer, and is suitable in increasing the rate of decrease in adhesive force during the voltage application.

Commercially available products of the ionic liquid include, for example, "ELEXCEL AS-110", "ELEXCEL MP-442", "ELEXCEL IL-210", "ELEXCEL MP-471", "ELEXCEL MP-456" and "ELEXCEL AS-804" (trade names, manufactured by DKS Co. Ltd.); "HMI-FSI" (trade name, manufactured by Mitsubishi Materials Corporation); and "CIL-312" and "CIL-313" (trade names, manufactured by Japan Carlit Co., Ltd.)

The ionic conductivity of the ionic liquid is preferably 0.1 mS/cm or more and 10 mS/cm or less. The upper limit of the ionic conductivity is more preferably 5 mS/cm, and still more preferably 3 mS/cm, and the lower limit thereof is more preferably 0.3 mS/cm, and still more preferably 0.5 mS/cm. When the ionic liquid has the ionic conductivity within this range, the adhesive force is sufficiently decreased even in a low voltage. The ionic conductivity can be measured by an AC impedance method using, for example, 1260 frequency response analyzer manufactured by Solartron.

The content (blending amount) of the ionic liquid in the adhesive composition of the present embodiment is preferably 0.5 parts by mass or more per 100 parts by mass of the polymer from the viewpoint of decreasing the adhesive force during voltage application and is preferably 30 parts by mass or less per 100 parts by weight of the polymer from the viewpoint of increasing the initial adhesive force. From the same viewpoints, the content is more preferably 20 parts by mass or less, still more preferably 15 parts by mass or less, particularly preferably 10 parts by mass or less, and most preferably 5 parts by mass or less. In addition, the content is more preferably 0.6 parts by mass or more, still more preferably 0.8 parts by mass or more, particularly preferably 1.0 part by mass or more, and most preferably 1.5 parts

by mass or more.

(Other components)

The adhesive composition of the present embodiment may contain one or more components other than the polymer and the ionic liquid (hereinafter, may also be referred to as "other components"), if necessary, as long as the effects of the present invention are not impaired. Hereinafter, other components that may be contained in the adhesive composition of the present embodiment will be described.

The adhesive composition of the present embodiment may contain an ionic additive. As the ionic additive, for example, an ionic solid can be used.

The ionic solid is an ionic substance that is solid at 25°C. The ionic solid is not limited, but for example, among ionic substances obtained by combining the anions and cations exemplified in the above-mentioned description for the ionic liquid, the solid ones can be used. When the adhesive composition contains an ionic solid, the content of the ionic solid is preferably 0.5 parts by mass or more and 10 parts by mass or less, per 100 parts by mass of the polymer.

The adhesive composition of the present embodiment may contain a crosslinking agent, if necessary, for the purpose of improving creeping property or shear property by crosslinking the polymers. Examples of the crosslinking agent include an isocyanate-based crosslinking agent, an epoxy-based crosslinking agent, a melamine-based crosslinking agent, a peroxide-based crosslinking agent, a urea-based crosslinking agent, a metal alkoxide-based crosslinking agent, a metal chelate-based crosslinking agent, a metal salt-based crosslinking agent, an oxazoline-based crosslinking agent, an aziridine-based crosslinking agent, and an amine-based crosslinking agent. Examples of the isocyanate-based crosslinking agent include polycarbodiimide, toluene diisocyanate and methylene bisphenyl isocyanate. Examples of the epoxy-based crosslinking agent include N,N,N',N'-tetraglycidyl-m-xylenediamine, diglycidylaniline, 1,3-bis(N,N-diglycidylaminomethyl) cyclohexane, and 1,6-hexanediol diglycidyl ether. When the crosslinking agent is contained, the content thereof is preferably 0.1 parts by mass or more and 50 parts by mass or less per 100 parts by mass of the polymer. The crosslinking agent can be used alone or a combination of two or more kinds thereof may be used.

The adhesive composition of the present embodiment may contain polyethylene glycol, if necessary, for the purpose of assisting the movement of the ionic liquid during voltage application. Polyethylene glycol having a number average molecular weight of 100 to 6,000 can be used. When polyethylene glycol is contained, the content thereof is preferably 0.1 parts by mass or more and 30 parts by mass or less, per 100 parts by mass of the polymer.

The adhesive composition of the present embodiment may contain a conductive filler, if necessary, for the purpose of imparting conductivity to the adhesive composition. The conductive filler is not limited, but as the filler, the general and/or conventional conductive fillers can be used. For example, graphite, carbon black, carbon fiber, and a metal powder such as silver or copper can be used. When the conductive filler is contained, the content thereof is preferably 0.1 parts by mass or more and 200 parts by mass or less, per 100 parts by mass of the polymer.

The adhesive composition of the present embodiment may further contain, if necessary, various additives such as a filler, a plasticizer, an age resister, an antioxidant, a pigment (a dye), a flame retardant, a solvent, a surfactant (leveling agent), a rust inhibitor, a tackifier, a tackifying resin, and an antistatic agent. The total content of these components is not limited as long as the effects of the present invention are exhibited, but is preferably 0.01 parts by mass or more and 20 parts by mass or less, more preferably 10 parts by mass or less, and still more preferably 5 parts by mass or less, per 100 parts by mass of the polymer.

Examples of the filler include silica, iron oxide, zinc oxide, aluminum oxide, titanium oxide, barium oxide, magnesium oxide, calcium carbonate, magnesium carbonate, zinc carbonate, pyrophyllite clay, kaolin clay, and calcined clay.

As the plasticizer, the conventional plasticizers that are used the typical resin compositions can be used. Examples thereof include: oils such as paraffin oil and process oil; liquid rubber such as liquid polyisoprene, liquid polybutadiene, and liquid ethylene-propylene rubber; tetrahydrophthalic acid, azelaic acid, benzoic acid, phthalic acid, trimellitic acid, pyromellitic acid, adipic acid, sebacic acid, fumaric acid, maleic acid, itaconic acid, citric acid and derivatives thereof; dioctyl phthalate (DOP), dibutyl phthalate (DBP), dioctyl adipate, diisononyl adipate (DINA), and isodecyl succinate.

Examples of the age resister include hindered phenol-based compounds, and aliphatic or aromatic hindered amine-based compounds.

Examples of the antioxidant include butylhydroxytoluene (BHT) and butylhydroxyanisole (BHA).

Examples of the pigment include an inorganic pigment such as titanium dioxide, zinc oxide, ultramarine, red iron oxide, lithopone, lead, cadmium, iron, cobalt, aluminum, hydrochloride or sulfate, and an organic pigment such as an azo pigment or a copper phthalocyanine pigment.

Examples of the rust inhibitor include zinc phosphate, a tannic acid derivative, phosphate, basic sulfonate, and various rust preventive pigments.

Examples of the adhesion-imparting agent include a titanium coupling agent and a zirconium coupling agent.

Examples of the antistatic agent include, in general, a quaternary ammonium salt or a hydrophilic compound such as polyglycolic acid or ethylene oxide derivative.

Examples of the tackifying resin include a polyamide-based tackifying resin, an epoxy-based tackifying resin and an elastomer-based tackifying resin, in addition to a rosin-based tackifying resin, a terpene-based tackifying resin, a phenol-based tackifying resin, a hydrocarbon-based tackifying resin and a ketone-based tackifying resin. The tackifying resin can be used alone or a combination of two or more kinds thereof may be used.

(Method for producing adhesive sheet)

For the method for producing the above electrolyte-containing adhesive layer, a known or common production method can be used. For example, the electrolyte-containing adhesive layer may be produced by a method of coating a solution in which the above adhesive composition is dissolved in a solvent if necessary, onto a separator, and performing drying and/or curing. In addition, the electrolyte-free adhesive layer may be produced by a method of coating a solution in which an adhesive composition free of an electrolyte is dissolved in a solvent if necessary, onto a separator, and performing drying and/or curing. As the solvent, those exemplified above can be used.

In the above coating, a common coater (for example, a gravure roll coater, a reverse roll coater, a kiss roll coater, a dip roll coater, a bar coater, a knife coater, and a spray roll coater) can be used.

With the above method, the electrolyte-containing adhesive layer can be produced. By laminating the electrolyte-containing adhesive layer and an electrolyte-free adhesive layer on the above substrate, conductive layer, and conduction substrate as appropriate, the adhesive sheet can be produced. The adhesive sheet may be produced by using the above substrate, conductive layer and conduction substrate, instead of the separator and coating the adhesive composition onto these members. The electrolyte-free adhesive layer containing no electrolyte can be produced in the same manner as the above-mentioned method for producing an electrolyte-containing adhesive layer, except that an electrolyte is not used in the adhesive composition.

<Method for Producing Adhesive Composition>

The adhesive composition of the present invention can be produced by appropriately stirring and mixing the polymer, the ionic liquid and the additives, and a crosslinking agent, polyethylene glycol, a conductive filler and the like, which are blended therewith if necessary, but the production method is not limited.

(Uses of adhesive sheet)

The conventional debonding technology includes an adhesive layer that is cured by ultraviolet (UV) irradiation and debonded, and an adhesive layer that is debonded by heat. The adhesive sheet using such an adhesive layer cannot be used when ultraviolet (UV) irradiation is difficult or damages occurs in a member, which is an adherend, by heat. The adhesive sheet of the present embodiment having the electrolyte-containing adhesive layer does not use ultraviolet rays and heat, and thus debonding can be easily performed by applying a voltage without damaging a member, which is an adherend. Thus, the adhesive sheet of the present embodiment is suitable for use in fixation of a secondary battery (for example, lithium ion battery pack) used in a mobile device such as a smart phone, mobile phone, a notebook computer, a video camera or a digital camera, to a case.

Examples of a rigid member to be adhered by the adhesive sheet of the present embodiment include a silicon substrate, a sapphire substrate for LED, an SiC substrate and a metal base substrate for use in a semiconductor wafer; a TFT substrate and a color filter substrate for a display; and a base substrate for an organic EL panel. Examples of a brittle member to be adhered by a double-sided adhesive sheet include a semiconductor substrate such as a compound semiconductor substrate; a silicon substrate for use in MEMS (Micro Electro Mechanical Systems) device, a passive matrix substrate, a surface cover glass, OGS (One Glass Solution) substrate in which the cover glass is provided on a touch panel sensor, an organic substrate and an organic/inorganic hybrid substrate including silsesquioxane as a main component for a smart phone; a flexible glass substrate for a flexible display; and a graphene sheet.

The adhesive sheet can be used as a temporary suction member for transporting members as the adhesive force can be recovered when a predetermined time elapses after a voltage has been applied to allow the members to firmly bond to each other, and the adherend can be easily separated by applying the voltage again.

[Adhered Body]

An adhered body of the present embodiment has a laminate structure part including an adherend having a metal adherend surface, and an adhesive sheet having an electrolyte-containing adhesive layer adhered to the metal adherend surface. Examples of the adherend having a metal adherend surface include those made of metals containing,

for example, aluminum, copper, iron, magnesium, tin, silver, and lead as a main component. Among these, a metal containing aluminum is preferred.

Examples of the adhered body of the present embodiment include an adhered body including the adhesive sheet X1 and adherends having a metal adherend surface provided on both surfaces of the electrolyte-containing adhesive layer 1; an adhered body including the adhesive sheet X2, an adherend having a metal adherend surface provided on the electrolyte-containing adhesive layer 1 side, and an adherend provided on the adhesive layer 2 side; and an adhered body including the adhesive sheet X3 and adherends provided on both surfaces of the adhesive layer 2.

## Examples

Hereinafter, the present invention will be specifically described with reference to Examples, but the present invention is not limited to these Examples. The weight average molecular weight described below is measured using a gel permeation chromatograph (GPC) method by the above-described method.

(Preparation of acrylic polymer 1 solution)

Into a separable flask, 96 parts by mass of n-butyl acrylate (BA) and 4 parts by mass of acrylic acid (AA) as monomer components and 150 parts by mass of ethyl acetate as a polymerization solvent were charged and stirred for 1 hour with nitrogen gas introduced. In this manner, oxygen in the polymerization system was removed, and then 0.2 parts by mass of 2,2'-azobisisobutyronitrile (AIBN) as a polymerization initiator was added. The temperature was raised to 63°C and a reaction was performed for 6 hours. Thereafter, ethyl acetate was added to obtain an acrylic polymer 1 solution having a solid content concentration of 40% by mass. The weight average molecular weight (Mw) of the acrylic polymer 1 was 600,000.

[Examples 1 and 2]

The acrylic polymer 1 solution obtained above, and the polymer, the crosslinking agent, the ionic liquid, and the additive shown below were added, stirred and mixed to obtain adhesive compositions of Examples 1 and 2. Table 1 shows the blending amount of each component.

The values of each component in Table 1 mean parts by mass. Further, the blending amount (parts by mass) of the polymer indicates the blending amount (parts by mass) of the solid content in the polymer solution.

The abbreviations for the polymers, the crosslinking agents, the ionic liquids, and the additives in Table 1 are as follows.

(Polymer)

SOMAREX 530: anionic polyacrylamide polymer (ionic polymer), trade name "SOMAREX 530", manufactured by SOMAR Corporation

(Ionic liquid)

AS-110: cation: 1-ethyl-3-methylimidazolium cation, anion: bis(fluorosulfonyl)imide anion, trade name "ELEXCEL AS-110", manufactured by DKS Co. Ltd.

(Crosslinking agent)

V-05: polycarbodiimide resin, trade name "CARBODILITE V-05", manufactured by Nisshinbo Chemical Inc.

(Additive)

EMI-nitrate: 1-ethyl-3-methylimidazolium nitrate, manufactured by Tokyo Chemical Industry Co., Ltd.

(Initial adhesive force)

The adhesive composition of each example was coated, using an applicator, onto a release-treated surface of a polyethylene terephthalate separator ("MRF3 8" (trade name) manufactured by Mitsubishi Plastics, Inc.) whose surface was subjected to a release treatment to have a uniform thickness. Next, the resulting coating film was dried by heating at 130°C for 3 minutes to obtain an electrolyte-containing adhesive layer (adhesive sheet) having a thickness of 30 μm.

Next, the obtained electrolyte-containing adhesive layer (adhesive sheet) was made into a sheet having a size of 20 mm × 80 mm, and a metal layer surface of a metal layer-attached film (trade name "V-bel", manufactured by Oike Advanced Film Co., Ltd., thickness: 50 μm, size: 20 mm × 100 mm) was adhered to a separator-free surface of the adhesive sheet, to obtain a substrate-attached single-sided adhesive sheet. The separator of the substrate-attached single-sided adhesive sheet was peeled off. A stainless steel plate (SUS304BA, size: 100 mm × 100 mm) as an adherend was adhered to the surface of the single-sided adhesive sheet where the separator had been peeled off such that one end of the adhesive sheet was protruded from the adherend by approximately 2 mm, and was pressed by reciprocating a 2 kg roller once. After allowing the resultant one to stand for 30 minutes, an adhered body sample including a stainless steel plate, an electrolyte-containing adhesive layer (adhesive sheet) and a metal layer-attached substrate was obtained. The initial adhesive force in a 180° peeling test (tensile rate: 300 mm/min, debonding temperature: 23°C) was measured with a peeling tester. The measurement results are shown in Table 1.

(Adhesive force during voltage application)

An adhered body sample including a stainless steel plate 6, an electrically debondable adhesive layer (adhesive sheet) 1' and a metal layer-attached film (conduction substrate) 5' was prepared in the same manner as that for the above initial adhesive force. Positive electrodes were attached to α and β and a negative electrode was attached to a metal adherend in FIG. 7, and while voltage application was performed at a voltage of 10 V for 10 seconds with a DC current machine, peeling was performed in the direction of the arrow in FIG. 7 with a peeling tester. Accordingly, the adhesive force in the 180° peeling test (tensile rate: 300 mm/min, debonding temperature: 23°C) was measured. The value of [(adhesive force during voltage application / initial adhesive force) × 100] was taken as the adhesive force recovery rate (first time) [%]. The measurement results are shown in Table 1 and Table 2.

(Adhesive force after predetermined time from stop of voltage application)

An adhered body sample was prepared in the same manner as that for the above initial adhesive force. A positive electrode was attached to the substrate and a negative electrode was attached to the metal adherend, and voltage application was performed at a voltage of 10 V for 10 seconds with a DC current machine. Thereafter, the electrodes were removed, and after a predetermined time (10 seconds, 30 seconds, 1 minute, 2 minutes, 5 minutes, 30 minutes, and 1 hour) had elapsed, the adhesive force in the 180° peeling test (tensile rate: 300 mm/min, debonding temperature: 23°C) was measured with a peeling tester. The value of [(adhesive force after predetermined time from stop of voltage application / initial adhesive force) × 100] was defined as the adhesive force recovery rate [%] after a predetermined time. The measurement results are shown in Table 1.

A recovery rate of 6% or less after 30 seconds was evaluated as "◎", a recovery rate of more than 6% and 30% or less after 30 seconds was evaluated as "○", and a recovery rate of more than 30% after 30 seconds was evaluated as "×".

(Measurement of water content in electrolyte-containing adhesive layer)

The electrolyte-containing adhesive layer obtained using the adhesive composition of each example in the same manner as above was left to stand in an environment of 23°C and 50% RH for 3 days, and then the water content of the adhesive layer was measured by the Karl Fischer water vaporization-coulometric titration method (JIS K 0113:2005). Specifically, using the Hiranuma trace moisture measuring device AQ-2100 manufactured by HIRANUMA SANGYO Co., Ltd., the amount of water generated by heating vaporization at 130°C for 30 minutes was measured, and the proportion to the sample mass before heating was defined as the water content. That is, the water content was obtained according to the following equation.

$$\text{Water content (\%)} = (\text{water amount measured by Karl Fischer} / \text{total sample mass before measurement}) \times 100$$

[Table 1]

<table>
<tr><td colspan="3"></td><td>Example 1</td><td>Example 2</td></tr>
<tr><td rowspan="5">Components of electrolyte-containing adhesive layer</td><td rowspan="2">Polymer</td><td>Acrylic polymer-1</td><td>100</td><td>100</td></tr>
<tr><td>SOMAREX 530</td><td>0.2</td><td></td></tr>
<tr><td>Ionic liquid</td><td>AS-100</td><td>5</td><td>5</td></tr>
<tr><td>Crosslinking agent</td><td>V-05</td><td>1</td><td>1</td></tr>
<tr><td>Additive</td><td>EMI-nitrate</td><td>2</td><td></td></tr>
<tr><td>Physical property</td><td colspan="2">Water content (%)</td><td>0.74</td><td>0.48</td></tr>
<tr><td rowspan="17">Evaluation</td><td colspan="2">Initial adhesive force (N/20 mm)</td><td>6.14</td><td>7.85</td></tr>
<tr><td colspan="2">Adhesive force (N/20 mm) during voltage application</td><td>0.03</td><td>0.04</td></tr>
<tr><td rowspan="7">Adhesive force (N/20 mm) after predetermined time from voltage application</td><td>After 10 seconds</td><td>0.20</td><td>0.26</td></tr>
<tr><td>After 30 seconds</td><td>0.25</td><td>0.42</td></tr>
<tr><td>After 1 minute</td><td>0.56</td><td>0.86</td></tr>
<tr><td>After 2 minutes</td><td>0.71</td><td>2.52</td></tr>
<tr><td>After 5 minutes</td><td>0.91</td><td>5.16</td></tr>
<tr><td>After 30 minutes</td><td>4.05</td><td>8.16</td></tr>
<tr><td>After 1 hour</td><td>6.44</td><td>8.28</td></tr>
<tr><td rowspan="7">Adhesive force recovery rate (%)</td><td>After 10 seconds</td><td>3.18</td><td>3.31</td></tr>
<tr><td>After 30 seconds</td><td>4.04</td><td>5.35</td></tr>
<tr><td>After 1 minute</td><td>9.14</td><td>10.96</td></tr>
<tr><td>After 2 minutes</td><td>11.56</td><td>32.10</td></tr>
<tr><td>After 5 minutes</td><td>14.82</td><td>65.73</td></tr>
<tr><td>After 30 minutes</td><td>66.01</td><td>103.95</td></tr>
<tr><td>After 1 hour</td><td>104.89</td><td>105.48</td></tr>
<tr><td colspan="2">Recovery rate (%) after 30 seconds</td><td>◎</td><td>◎</td></tr>
</table>

(Adhesive force after bonding maintenance step)

The same adhered body sample as that made for the above initial adhesive force was prepared. A positive electrode was attached to the substrate and a negative electrode was attached to the metal adherend, and voltage application was performed at a voltage of 10 V for 10 seconds with a DC current machine. Then, the electrode was removed and the adhered body sample was left for a predetermined time (1 minute, 30 minutes, and 1 hour). Again, a positive electrode was attached to the substrate and a negative electrode was attached to the metal adherend, and while voltage application was performed at a voltage of 10 V for 10 seconds with a DC current machine, and the adhesive force (adhesive force during further voltage application) in the 180° peeling test (tensile rate: 300 mm/min, debonding temperature: 23°C) was measured with a peeling tester. The value of [(adhesive force during further voltage application / initial adhesive force) × 100] was defined as the adhesive force recovery rate [%] after the bonding maintenance step. The measurement results are shown in Table 2.

[Table 2]

| | Example 1 | Example 2 |
|---|---|---|
| Initial adhesive force (N/20 mm) | 6.14 | 7.85 |
| Adhesive force (N/20 mm) during voltage application | 0.03 | 0.04 |
| Adhesive force (N/20 mm) during further voltage application after leaving for 1 minute after stop of voltage application | 0.02 | 0.03 |
| Adhesive force (N/20 mm) during further voltage application after leaving for 30 minutes after stop of voltage application | 0.02 | 0.02 |
| Adhesive force (N/20 mm) during further voltage application after leaving for 1 hour after stop of voltage application | 0.03 | 0.03 |
| Adhesive force recovery rate (first time) (%) | 0.49 | 0.51 |
| Adhesive force recovery rate (after 1 minute) (%) | 0.39 | 0.38 |
| Adhesive force recovery rate (after 30 minutes) (%) | 0.40 | 0.25 |
| Adhesive force recovery rate (after 1 hour) (%) | 0.41 | 0.38 |

[Comparative Example 1]

A thermal release tape: NO. 3195MS (manufactured by NITTO DENKO CORPORATION) was formed into a sheet having a size of 20 mm × 80 mm, and a stainless steel plate (SUS304BA, size: 100 mm × 100 mm) as an adherend was adhered to the surface of the thermal release tape where the separator had been peeled off such that one end of the thermal release tape was protruded from the adherend by approximately 2 mm, and was pressed by reciprocating a 2 kg roller once. After the resultant one was allowed to stand for 30 minutes, an adhered body sample including a stainless steel plate, an adhesive layer (thermal release tape) and a metal layer-attached substrate was obtained. The initial adhesive force in a 180° peeling test (tensile rate: 300 mm/min, debonding temperature: 23°C) was measured with a peeling tester. The measurement results are shown in Table 3.

After heating the adhered body sample in an oven at 120°C for 1 minute, the adhesive force immediately after cooling to 23°C was measured (adhesive force after heating).

Further, the adhesive force of the heated sample after the heated sample was left at 23°C for 30 minutes was measured (adhesive force after left for 30 minutes after heating).

Further, the heated sample after left for 30 minutes was left in an oven at 120°C for 1 minute. The adhesive force after reheating was measured (adhesive force after reheating).

Further, the sample after the above reheating was debonded from the adherend, and then a new second adherend was adhered to the sample by pressing by reciprocating a 2 kg roller once. After the resultant one was allowed to stand for 30 minutes, the adhesive force after adhering was measured (adhesive force after adhering to second adherend).

The measurement results are shown in Table 3.

[Table 3]

| Thermal release tape: NO. 3195MS | Adhesive force/ N/20 mm |
|---|---|
| Initial adhesive force | 4.56 |
| Adhesive force after heating | 0.00 |
| Adhesive force after left for 30 minutes after heating | 0.00 |
| Reheating | 0.00 |
| Adhesive force after adhering to second adherend | 0.00 |

[Comparative Example 2]

The initial adhesive force was measured in the same manner as in Comparative Example 1, except that the thermal release tape: NO. 3195MS was changed to a UV release tape: ELP-DU-300 (manufactured by NITTO DENKO

CORPORATION).

The adhesive force was measured after UV irradiation was performed for 1 minute from the adhesive tape side at intervals of 60 cm with a black light of 3 mW (adhesive force after UV irradiation).

Further, the adhesive force of the sample after left at 23°C for 30 minutes after the above UV irradiation was measured (adhesive force after left for 30 minutes after UV irradiation).

Further, UV irradiation was performed on the sample after left for 30 minutes, under the same conditions as above, and then the adhesive force was measured (adhesive force after further UV irradiation).

Further, the adhesive tape after the above further UV irradiation was debonded from the adherend, and then a new second adherend was adhered to the adhesive tape by pressing by reciprocating a 2 kg roller once. After the resultant one was allowed to stand for 30 minutes, the adhesive force after adhering was measured (adhesive force after adhering to second adherend).

The measurement results are shown in Table 4.

[Table 4]

| UV release tape: ELP-DU-300 | Adhesive force/ N/20 mm |
|---|---|
| Initial adhesive force | 13.80 |
| Adhesive force after UV irradiation | 1.29 |
| Adhesive force after left for 30 minutes after UV irradiation | 1.30 |
| Adhesive force after further UV irradiation | 1.13 |
| Adhesive force after adhering to second adherend | 0.00 |

INDUSTRIAL APPLICABILITY

The separation method for an adherend according to the present invention allows members to firmly bond to each other by the recovery of the adhesive force when a predetermined time elapses after a voltage has been applied, and can easily separate the adherend by applying the voltage again. In addition, the bonding method for an adherend according to the present invention allows members to firmly bond to each other by the recovery of the adhesive force when a predetermined time elapses after a voltage has been applied.

Although the present invention has been described in detail and with reference to particular embodiments, it will be apparent to those skilled in the art that various changes and modifications can be made without departing from the spirit and scope of the invention.

This application is based on a Japanese Patent Application (Japanese Patent Application No. 2018-184565) filed September 28, 2018, the contents of which are incorporated herein by reference.

REFERENCE SIGNS LIST

| | |
|---|---|
| X1, X2, X3 | adhesive sheet |
| Y1, Y2, Y4 | conductive adherend |
| Y3, Y5, Y6 | non-conductive adherend |
| 1, 1', 11, 12, 13 | electrolyte-containing adhesive layer |
| 2, 21, 22, 23 | electrolyte-free adhesive layer |
| 5, 5', 30, 40, 50 | conduction substrate |
| 3, 31, 41, 51 | substrate |
| 4, 32, 42, 52 | conductive layer |
| 6 | adherend (SUS304) |

**Claims**

**1.** A separation method for an adherend, comprising:

a first voltage application step of applying a voltage to an electrolyte-containing adhesive layer to change an

adhesive force so as to generate a potential difference in a thickness direction of the electrolyte-containing adhesive layer in a state where the electrolyte-containing adhesive layer in an adhesive sheet containing at least the electrolyte-containing adhesive layer is allowed to bond to an adherend;
a bonding maintenance step of recovering the adhesive force by allowing a predetermined time to elapse in the state where the electrolyte-containing adhesive layer is allowed to bond to the adherend, after the first voltage application step;
a second voltage application step of applying a voltage to the electrolyte-containing adhesive layer to change the adhesive force so as to generate a potential difference in the thickness direction of the electrolyte-containing adhesive layer in the state where the electrolyte-containing adhesive layer is allowed to bond to the adherend, after the bonding maintenance step; and
a separation step of separating the electrolyte-containing adhesive layer and the adherend.

**2.** The separation method for an adherend according to claim 1, wherein the second voltage application step and the separation step are performed at the same time.

**3.** The separation method for an adherend according to claim 1, wherein the separation step is performed after the second voltage application step.

**4.** The separation method for an adherend according to any one of claims 1 to 3, wherein in the bonding maintenance step, a recovery rate of the adhesive force of the electrolyte-containing adhesive layer is 30% or less 30 seconds after applying the voltage is stopped.

**5.** The separation method for an adherend according to any one of claims 1 to 4, wherein both of the voltage applied in the first voltage application step and the voltage applied in the second voltage application step are 20 V or less.

**6.** The separation method for an adherend according to any one of claims 1 to 5, wherein
one surface of the electrolyte-containing adhesive layer is allowed to bond to a first conductive adherend, and the other surface of the electrolyte-containing adhesive layer is allowed to bond to a second conductive adherend, and
in the first voltage application step and the second voltage application step, the voltage is applied to the electrolyte-containing adhesive layer via the first conductive adherend and the second conductive adherend.

**7.** The separation method for an adherend according to any one of claims 1 to 5, wherein
the adhesive sheet has a laminate structure including the electrolyte-containing adhesive layer, a first adhesive layer, and a conductive layer located between the electrolyte-containing adhesive layer and the first adhesive layer and bonding to the electrolyte-containing adhesive layer,
the electrolyte-containing adhesive layer is allowed to bond to a conductive adherend, and the first adhesive layer is allowed to bond to another adherend, and
in the first voltage application step and the second voltage application step, the voltage is applied to the electrolyte-containing adhesive layer via the conductive layer and the conductive adherend.

**8.** The separation method for an adherend according to any one of claims 1 to 5, wherein
the adhesive sheet has a laminate structure including a first adhesive layer, the electrolyte-containing adhesive layer, a second adhesive layer, a first conductive layer located between the first adhesive layer and the electrolyte-containing adhesive layer and bonding to the electrolyte-containing adhesive layer, and a second conductive layer located between the second adhesive layer and the electrolyte-containing adhesive layer and bonding to the electrolyte-containing adhesive layer,
the first adhesive layer is allowed to bond to a first adherend, and the second adhesive layer is allowed to bond to a second adherend,
in the first voltage application step and the second voltage application step, the voltage is applied to the electrolyte-containing adhesive layer via the first conductive layer and the second conductive layer.

**9.** The separation method for an adherend according to any one of claims 1 to 8, wherein the electrolyte-containing adhesive layer has a thickness of 1 μm or more and 1,000 μm or less.

**10.** The separation method for an adherend according to any one of claims 1 to 9, wherein in the first voltage application step and the second voltage application step, an application time of the voltage is 60 seconds or shorter.

**11.** The separation method for an adherend according to any one of claims 1 to 10, wherein the electrolyte is an ionic liquid.

**12.** The separation method for an adherend according to any one of claims 1 to 11, wherein the electrolyte-containing adhesive layer has a water content of 0.4% or more after being stored in an environment of 23°C × 50% for 3 days.

**13.** The separation method for an adherend according to claim 11, wherein a cation of the ionic liquid is at least one cation selected from the group consisting of an imidazolium-based cation, a pyridinium-based cation, a pyrrolidinium-based cation, and an ammonium-based cation.

**14.** The separation method for an adherend according to claim 13, wherein a molecular weight of the cation of the ionic liquid is 300 or less.

**15.** The separation method for an adherend according to any one of claims 11 to 14, wherein a polymer is contained in an adhesive composition for forming the electrolyte-containing adhesive layer, and the content of the electrolyte is 0.5 parts by mass or more and 30 parts by mass or less, per 100 parts by mass of the polymer.

**16.** A bonding method comprising:

a first voltage application step of applying a voltage to an electrolyte-containing adhesive layer to change an adhesive force so as to generate a potential difference in a thickness direction of the electrolyte-containing adhesive layer in a state where the electrolyte-containing adhesive layer in an adhesive sheet containing at least the electrolyte-containing adhesive layer is allowed to bond to an adherend; and

a bonding maintenance step of recovering the adhesive force by allowing a predetermined time to elapse in the state where the electrolyte-containing adhesive layer is allowed to bond to the adherend, after the first voltage application step.

FIG. 1

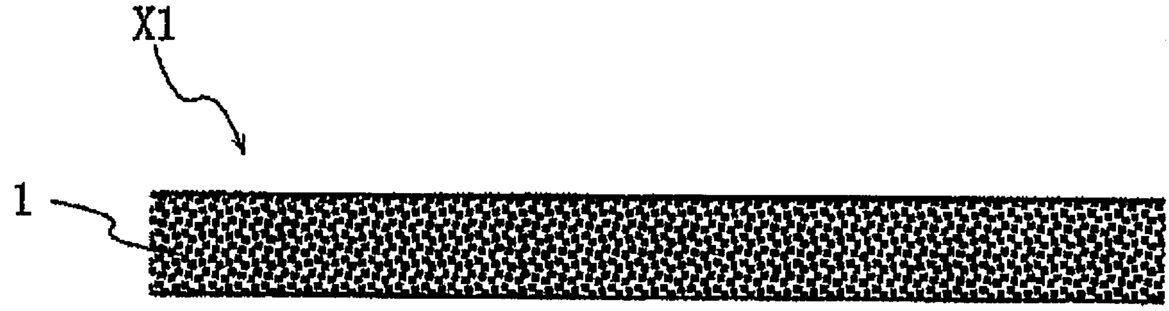

FIG. 2

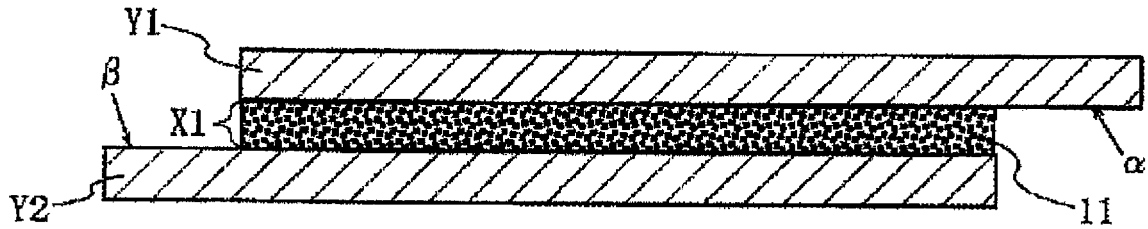

# FIG. 3

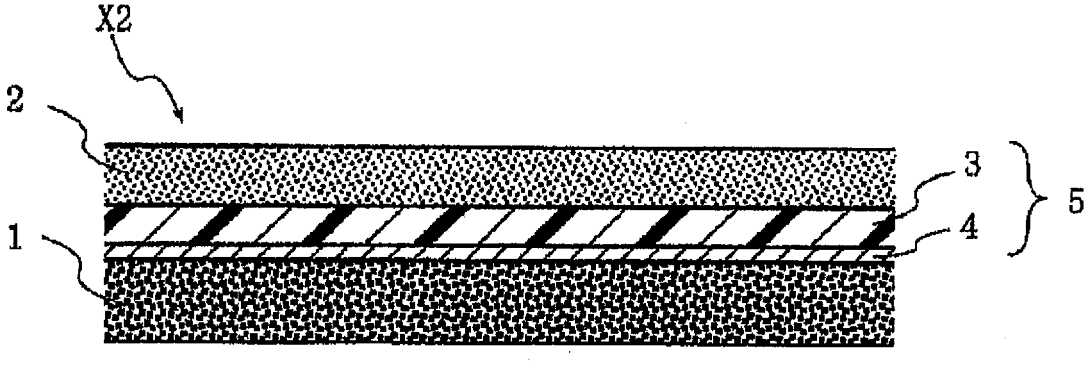

FIG. 4

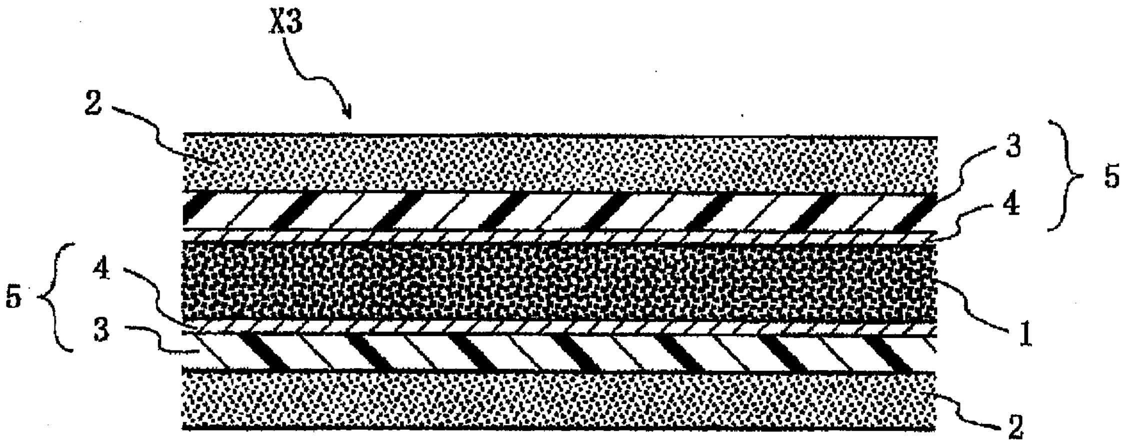

# FIG. 5

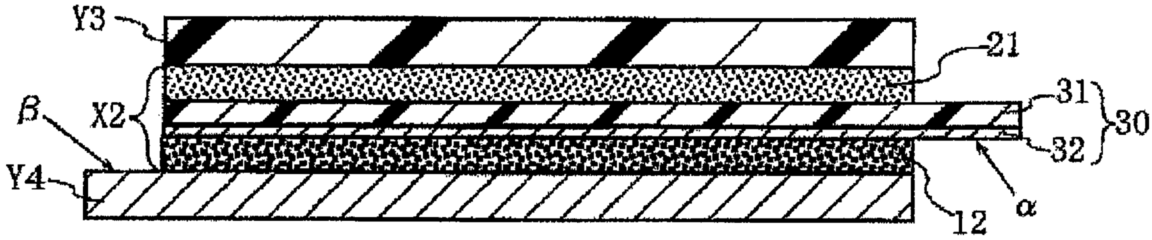

FIG. 6

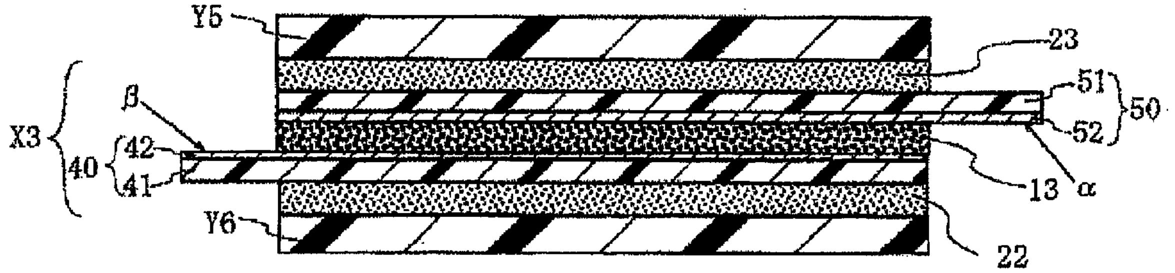

FIG. 7

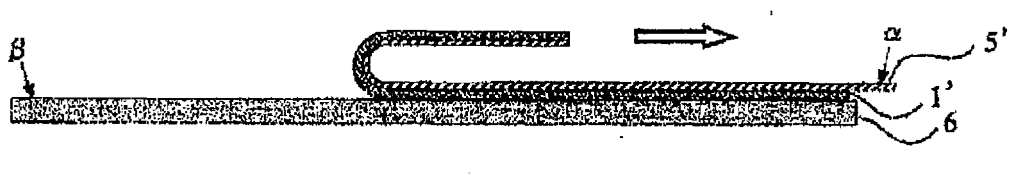

## INTERNATIONAL SEARCH REPORT

International application No.
PCT/JP2019/037719

A. CLASSIFICATION OF SUBJECT MATTER
Int.Cl. C09J7/38(2018.01)i, C09J5/00(2006.01)i, C09J11/06(2006.01)i, C09J201/00(2006.01)i, H01L21/304(2006.01)n
According to International Patent Classification (IPC) or to both national classification and IPC

B. FIELDS SEARCHED
Minimum documentation searched (classification system followed by classification symbols)
Int.Cl. C09J1/00-201/10, H01L21/304

Documentation searched other than minimum documentation to the extent that such documents are included in the fields searched

| | |
|---|---|
| Published examined utility model applications of Japan | 1922-1996 |
| Published unexamined utility model applications of Japan | 1971-2019 |
| Registered utility model specifications of Japan | 1996-2019 |
| Published registered utility model applications of Japan | 1994-2019 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2017-75289 A (NITTO DENKO CORP.) 20 April 2017, claim 1, paragraphs [0006]-[0007], [0011], [0015], [0018], [0055], [0057], [0066]-[0067], [0078]-[0079], [0102], table 1, comparative examples 1-6, examples 1-18 (Family: none) | 16<br>2 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 21 November 2019 (21.11.2019) | 10 December 2019 (10.12.2019) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2019/037719

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2017-95590 A (NITTO DENKO CORP.) 01 June 2017, claims 1-7, 9-11, paragraphs [0027], [0030], [0033], [0035], [0108], [0112], [0114], table 1, examples 1-15 (Family: none) | 1-16 |
| Y | JP 2006-160872 A (NITTO DENKO CORP.) 22 June 2006, paragraph [0082] (Family: none) | 1-16 |
| Y | JP 10-163135 A (DISCO CORPORATION) 19 June 1998, paragraph [0006] (Family: none) | 1-16 |
| A | WO 2018/159784 A1 (NITTO DENKO CORP.) 07 September 2018, entire text (Family: none) | 1-16 |
| A | JP 2010-37355 A (VIGTEQNOS CORPORATION) 18 February 2010, entire text (Family: none) | 1-16 |
| A | WO 2007/018239 A1 (THE YOKOHAMA RUBBER CO., LTD.) 15 February 2007, entire text & US 2009/0035580 A1, entire text & EP 1914285 A1 | 1-16 |
| A | JP 2014-189671 A (LINTEC CORP.) 06 October 2014, entire text, paragraphs [0019]-[0020] (Family: none) | 1-16 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2010037354 A
- JP 6097112 B
- JP 4139851 B
- JP 2018184565 A


### Non-patent literature cited in the description


- Polymer Handbook. John Wiley & Sons, Inc, 1989